(19) Europäisches Patentamt
European Patent Office
Office européen des brevets

(11) **EP 4 325 280 A1**

(12) **EUROPEAN PATENT APPLICATION**
published in accordance with Art. 153(4) EPC

(43) Date of publication:
**21.02.2024 Bulletin 2024/08**

(21) Application number: **22787978.0**

(22) Date of filing: **24.03.2022**

(51) International Patent Classification (IPC):
**G02B 27/02** (2006.01)   **G02B 3/00** (2006.01)
**G02C 11/00** (2006.01)   **H04N 5/64** (2006.01)

(52) Cooperative Patent Classification (CPC):
**G02B 3/00; G02B 27/02; G02C 11/00; H04N 5/64**

(86) International application number:
**PCT/JP2022/014130**

(87) International publication number:
**WO 2022/220053 (20.10.2022 Gazette 2022/42)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **15.04.2021   JP 2021069268**

(71) Applicant: **CANON KABUSHIKI KAISHA**
**Tokyo 146-8501 (JP)**

(72) Inventors:
• **KAJIMOTO, Norifumi**
**Tokyo 146-8501 (JP)**
• **TOHARA, Masakazu**
**Tokyo 146-8501 (JP)**
• **SANO, Hiroaki**
**Tokyo 146-8501 (JP)**
• **MATSUDA, Yojiro**
**Tokyo 146-8501 (JP)**

(74) Representative: **TBK**
**Bavariaring 4-6**
**80336 München (DE)**

(54) **IMAGE OBSERVATION DEVICE**

(57)   The present disclosure provides an apparatus including a display element including a plurality of light-emitting elements disposed two-dimensionally on a plane and a plurality of microlenses provided for corresponding ones of the plurality of light-emitting elements, and an ocular optical system, containing at least one reflective surface therein, that guides light from a display surface of the display element to an exit pupil, wherein in a peripheral part of the display element, a light emission center of each light-emitting element and a center of the microlens corresponding to the light-emitting element are shifted from each other in a direction parallel to the plane.

F I G. 4C

EP 4 325 280 A1

**Description**

TECHNICAL FIELD

The present invention relates to an image observation apparatus in which an image displayed on a display element can be observed through an ocular optical system.

BACKGROUND ART

A head-mounted display (HMD), which is worn on the head of an observer, is known as an image observation apparatus in which an image displayed on a display element can be observed through an ocular optical system. In such an HMD, an ocular optical system that bends the optical path is sometimes used to achieve both miniaturization and a wide view angle. A polarizing optical system that uses polarized light, a freeform prism having a reflective surface inside the lens, and the like can be given as examples of such an ocular optical system.

Such ocular optical systems are characterized by a shorter focal length, which increases the light emission angle from the display element at peripheral view angles and tends to degrade the viewing angle characteristics (causes shifts in the luminance and chromaticity) of the display element. Such systems are also prone to producing what is known as "ghost light", which is light that passes through an optical path not intended by design. For example, when a plastic lens is used as part of a polarizing optical system to reduce weight, birefringence within the plastic lens may disrupt the polarization state of the light and produce ghosting.

PTL 1 and PTL 2 disclose HMDs having ocular optical systems that use polarized light to provide a wide view angle. Furthermore, PTL 2 discloses that increasing the size of a color filter provided on the display element with distance from the center to the periphery improves the viewing angle characteristics at peripheral view angles.

CITATION LIST

PATENT LITERATURE

PTL 1: Japanese Patent Laid-Open No. 2019-053152
PTL 2: Japanese Patent Laid-Open No. 2019-61198

SUMMARY OF INVENTION

TECHNICAL PROBLEM

However, in the HMD disclosed in PTL 2, the light source and the center of the color filter are aligned such that the viewing angle characteristics in the normal direction of the display element are good, and thus ghosting caused by lens birefringence cannot be reduced.

Having been made in view of the above-described problem, the present invention provides an image observation apparatus that can reduce ghosting while improving the viewing angle characteristics at peripheral view angles of an ocular optical system configured to bend an optical path.

SOLUTION TO PROBLEM

An image observation apparatus according to the present invention includes: a display element including a plurality of light-emitting elements disposed two-dimensionally on a plane and a plurality of microlenses provided for corresponding ones of the plurality of light-emitting elements; and an ocular optical system, containing at least one reflective surface therein, that guides light from a display surface of the display element to an exit pupil. In a peripheral part of the display element, a light emission center of each light-emitting element and a center of the microlens corresponding to the light-emitting element are shifted from each other in a direction parallel to the plane.

ADVANTAGEOUS EFFECTS OF INVENTION

According to the present invention, ghosting can be reduced while improving the viewing angle characteristics at peripheral view angles of an ocular optical system configured to bend an optical path.

Other features and advantages of the present invention will be apparent from the following description taken in conjunction with the accompanying drawings. Note that the same reference numerals denote the same or like components throughout the accompanying drawings.

BRIEF DESCRIPTION OF DRAWINGS

The accompanying drawings, which are incorporated in and constitute a part of the specification, illustrate embodiments of the invention and, together with the description, serve to explain principles of the invention.

FIG. 1 is a plan view of a display element according to a first embodiment of the present invention.
FIG. 2 is an enlarged view of an edge of the display element in FIG. 1.
FIG. 3A is a cross-sectional view of the display element of the first embodiment.
FIG. 3B is a cross-sectional view of the display element of the first embodiment.
FIG. 3C is a cross-sectional view of the display element of the first embodiment.
FIG. 4A is a cross-sectional view of a display element which does not have microlenses.
FIG. 4B is a cross-sectional view of a display element in which microlenses are not shifted.
FIG. 4C is a cross-sectional view of the display element of the first embodiment.
FIG. 5A is a diagram illustrating optical conditions of light rays that become normal light and ghost light.
FIG. 5B is a diagram illustrating optical conditions of light rays that become normal light and ghost light.
FIG. 5C is a diagram illustrating optical conditions of light rays that become normal light and ghost light.
FIG. 6A is a diagram illustrating a relationship between light rays that become normal light and a shift amount $\Delta CF$ of the color filter.
FIG. 6B is a diagram illustrating a relationship between light rays that become normal light and a shift amount $\Delta CF$ of the color filter.
FIG. 7 is a plan view of the display element of the first embodiment.
FIG. 8A is a plan view of the display element of the first embodiment.
FIG. 8B is a plan view of the display element of the first embodiment.
FIG. 9 is a schematic diagram illustrating an example of a display device according to the first embodiment.
FIG. 10A is a diagram illustrating an image capturing device and an electronic device according to the first embodiment.
FIG. 10B is a diagram illustrating an image capturing device and an electronic device according to the first embodiment.
FIG. 11A is a diagram illustrating an example of a display device according to the first embodiment.
FIG. 11B is a diagram illustrating an example of a display device according to the first embodiment.
FIG. 12A is a diagram illustrating a lighting device and an automobile according to the first embodiment.
FIG. 12B is a diagram illustrating a lighting device and an automobile according to the first embodiment.
FIG. 13A is a diagram illustrating an example of an eyeglass-type display device according to the first embodiment.
FIG. 13B is a diagram illustrating an example of an eyeglass-type display device according to the first embodiment.
FIG. 14 is a diagram illustrating the configuration of an HMD according to the first embodiment.
FIG. 15 is an exterior view of the HMD according to the first embodiment.
FIG. 16 is a diagram illustrating the configuration of an ocular optical system in the first embodiment.
FIG. 17 is an optical path diagram of the ocular optical system in the first embodiment.
FIG. 18 is a diagram illustrating an optical path of ghost light in the first embodiment.
FIG. 19 is a diagram illustrating viewing angle characteristics at a horizontal edge of a display surface in the first embodiment.
FIG. 20 is a diagram illustrating the configuration of an HMD in a second embodiment.
FIG. 21 is a diagram illustrating the configuration of an ocular optical system in the second embodiment.
FIG. 22 is an optical path diagram of the ocular optical system in the second embodiment.
FIG. 23 is a diagram illustrating an optical path of ghost light in the second embodiment.
FIG. 24 is a diagram illustrating the configuration of an HMD in a third embodiment.
FIG. 25 is a diagram illustrating the configuration of an ocular optical system in the third embodiment.
FIG. 26 is an optical path diagram of the ocular optical system in the third embodiment.
FIG. 27A is a diagram illustrating an optical path of ghost light in the third embodiment.
FIG. 27B is a diagram illustrating an optical path of ghost light in the third embodiment.

DESCRIPTION OF EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

In embodiments of the present invention, ghosting can be reduced while improving the viewing angle characteristics at peripheral view angles of an ocular optical system that bends an optical path by shifting the center position of a microlens provided on a light-emitting element with respect to the light emission center position of the light-emitting element.

First, an embodiment of a display element that improves viewing angle characteristics and reduces ghosting will be described. Then, as examples of combinations of display elements and ocular optical systems that bend an optical path, a first embodiment and a second embodiment will describe embodiments of a polarizing optical system that uses polarized light, and a third embodiment will describe an embodiment that uses a freeform prism. Preferred forms of the ocular optical system that bends the optical path will be described in the embodiments.

Embodiments of the display element of the present invention will be described hereinafter with reference to the drawings. Note that for parts not specifically illustrated or described in the present specification, well-known or publicly-known techniques in the corresponding technical field are applied. Furthermore, the present invention is not intended to be limited to the embodiments described below.

First Embodiment

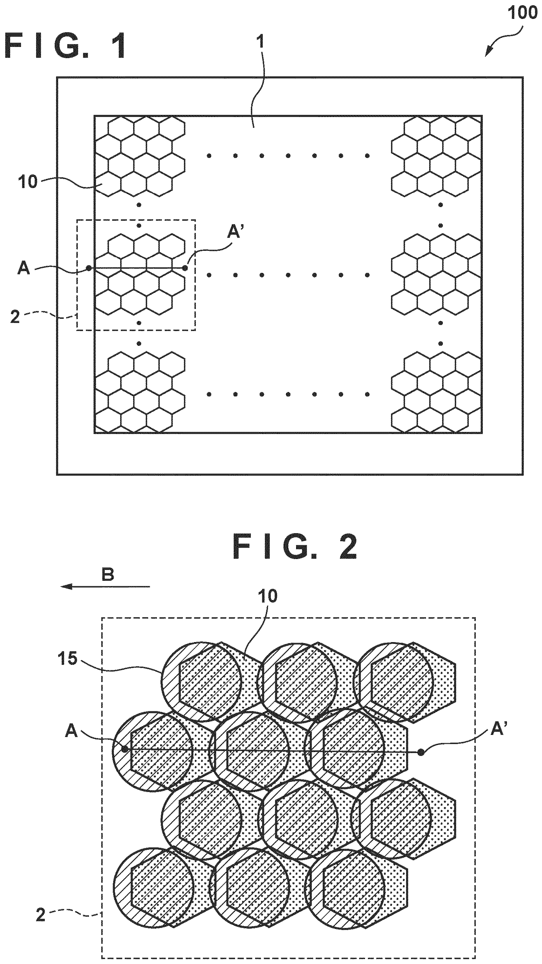

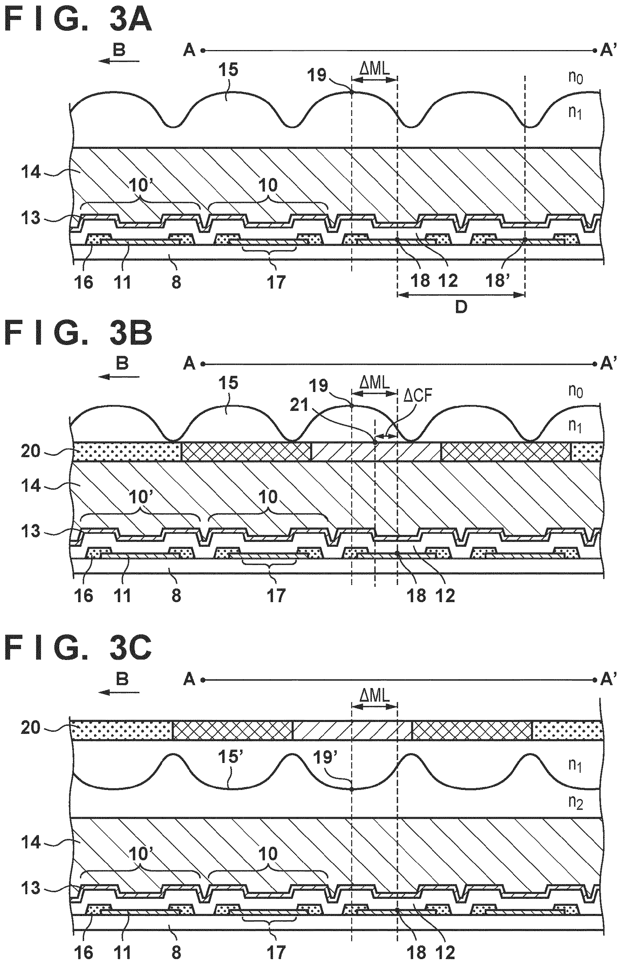

FIG. 1 is a plan view of a display element according to a first embodiment of the present invention. A display element 100 has a display region 1, in which light-emitting elements 10 are arranged two-dimensionally on a main surface (plane) of a substrate 8 (see FIGS. 3A to 3C), and which generates an image. However, the effect of the present invention is not dependent on the pixel array. In other words, a delta array such as that illustrated in FIG. 1 may be used, or a stripe array or a square array may be used.

FIG. 2 is a diagram illustrating an enlarged view of an edge region 2 of the display region 1 illustrated in FIG. 1. As illustrated in FIG. 2, in the edge region 2 (the display region 1), the light-emitting elements 10 disposed on the main surface of the substrate 8, and microlenses 15 through which light from light emission regions 17 (see FIGS. 3A to 3C) of the light-emitting elements 10 is incident, are provided. In plan view from a direction perpendicular to the main surface of the substrate 8, the center of the light emission region 17 of the light-emitting element 10 and the center of the microlens 15 are shifted in a direction parallel to the main surface. The edge region 2 is in the periphery of the center of the display region and is therefore sometimes called a "peripheral part".

FIG. 3A is a cross-sectional view of the edge region 2 cut along the A-A' line in FIG. 2, and illustrates a light-emitting element having convex microlenses on the opposite side from the substrate. An example in which an organic EL element is used as the light-emitting element 10 is illustrated here. In the drawings, the organic EL elements (the light-emitting elements 10) are disposed at a pitch D. The pitch D is the distance, in the direction of the main surface of the substrate 8, between a center position 18 of the light emission region 17 of a given light-emitting element 10 and a center position 18' of the light emission region 17 of the adjacent light-emitting element 10.

The light-emitting element 10 on the substrate 8 has a first electrode 11 disposed on the main surface of the substrate 8, an organic layer 12 including a light-emitting layer, and a second electrode 13 disposed on the first electrode 11 with the organic layer 12 interposed therebetween. Additionally, to maintain the characteristics of the light-emitting element 10 at the outermost periphery of the display region 1, dummy pixels 10' are disposed outside the range indicated by the line between points A and A', which is the edge of the display region 1. The dummy pixels 10' may be formed in a plurality of columns and a plurality of rows.

The organic layer 12 may be configured with a light-emitting layer emitting a single light emission color deposited as a common layer between the light-emitting elements 10, such that the display element 100 can display a single light emission color. The organic layer 12 may also be configured by patterning a light-emitting layer that emits a different color for each light-emitting element 10 such that the display element 100 can display at least two colors. Each pixel of the display element 100 covers the edge of the first electrode 11 and has an opening above the first electrode 11, and has an insulating layer 16 that functions as a bank, a protective layer 14 disposed on the second electrode 13, and the microlens 15. The light emitted from the light-emitting element 10 enters the microlens 15.

In the present embodiment, the microlens 15 is disposed offset from the light emission region 17 of the light-emitting element 10 in the direction indicated by the arrow B. The direction indicated by the arrow B is the direction in which the main light rays of an ocular optical system that bends the optical path are projected onto the main surface when the display element 100 is seen in plan view. By using such a configuration, the luminous intensity of light that reaches the pupil of an observer through the ocular optical system is greater than when the microlenses are not provided, the microlenses and the light emission regions are arranged so as to overlap in plan view, and the like, which improves the utilization efficiency of the light emitted by the light-emitting layer. In addition, the luminous intensity of light that passes through unintended optical paths and is perceived as ghosting by the observer is reduced. The effects will be described in greater detail later. It is desirable that a relationship between a refractive index n1 of the microlens and a refractive index n0 of the medium above the microlens in the present embodiment, illustrated in FIG. 3A, be n0 < n1. The light emission region 17 of the light-emitting element 10 refers to the area where the first electrode 11, the organic layer 12, and the second electrode 13 are layered in the opening in the insulating layer 16.

In each light-emitting element 10, the microlens 15 and the light emission region 17 being shifted means that a center position 19 of the microlens 15 and the center position 18 of the light emission region 17 do not overlap in plan view, and are instead separated by a given distance. The center of the microlens 15 is the center of gravity of a shape (outline) formed from lines connecting the edges in plan view. The edges of the microlens 15 are the positions where the height in the Z direction of the microlens 15, in a cross-sectional view thereof, is the lowest. In FIG. 3A, the cross-section of the microlens 15 is a spherical shape (partial spheres and hemispheres are also included in the spherical shape), in which case the center of the microlens 15 coincides with the apex of the microlens 15.

In the present embodiment, the microlens 15 is disposed so as to be shifted with respect to the light emission region 17 of the light-emitting element 10. In other words, the center 19 of the microlens 15 and the center position 18 of the light emission region 17 are separated by a given distance apart (not coincident) in a plan view of the surface of the substrate 8 on which the light-emitting elements 10 are disposed. Here, the cross-sectional shape of the microlens 15 is spherical, and thus the apex of the microlens 15 and the center of the light emission region 17 are also separated by a given distance.

In the present embodiment, the pitch of the microlenses 15 (the distance between the centers of adjacent microlenses in the plan view of the surface on which the light-emitting elements 10 of the substrate 8 are disposed) is constant. The pitch of the light-emitting elements 10 (the distance between the centers of the light emission regions of adjacent light-emitting elements 10 in the plan view of the surface on which the light-emitting elements 10 are disposed on the substrate 8) is also constant, and coincides with the pitch of the microlenses 15. Accordingly, the microlenses 15 and light emission regions 17 are shifted by a certain distance (a shift amount). In other words, the present embodiment describes an example in which the distance between the center of microlens 15 and the center of the light emission region 17 in plan view (a microlens shift amount) is constant for each pixel.

When the organic layer 12 is constituted by a layer that emits white light, a color filter 20 may be provided between the light-emitting element 10 and the microlens 15, as illustrated in FIG. 3B. FIG. 3B illustrates an example in which the color filter 20 is shifted with respect to the light emission region 17. In other words, a center 21 of the color filter 20 and the center 18 of the light emission region 17 are separated by a given distance in the plan view of the surface of the substrate 8 on which the light-emitting elements 10 are disposed. However, to suppress color shift, the color filter 20 may be disposed so as not to be shifted with respect to the light emission region 17. In other words, the center 21 of the color filter 20 and the center position 18 of the light emission region 17 may be arranged so as to coincide in the plan view of the surface of the substrate 8 on which the light-emitting elements 10 are disposed.

FIG. 3C is a cross-sectional schematic diagram illustrating a light-emitting device in which the color filters and the microlenses have different forms. Unlike the other embodiments, a microlens 15' has a shape which is convex in the downward direction in the drawing. The downward direction in the drawing can also be called a direction from a semi-transmissive electrode to a reflective electrode. The space between the microlens 15' and the protective layer 14 may be a gap, or may be filled with another material. However, it is desirable that the relationship between the refractive index n1 of the microlens and the refractive index n2 of the medium below the microlens be n2 < n1. In FIG. 3C, the color filter 20 is disposed above the microlens 15', but the color filter 20 may be disposed between the microlens 15' and the protective layer 14. The center of the microlens 15' is the center of gravity of a shape (outline) formed from lines connecting the edges in plan view. The edges of the microlens 15' are the positions where the height in the Z direction of the microlens 15, in a cross-sectional view thereof, is the lowest. In FIG. 3C, the cross-section of the microlens 15' is a spherical shape (partial spheres and hemispheres are also included in the spherical shape), in which case the center of the microlens 15' coincides with the apex of the microlens 15'.

The substrate 8 may be any material that can support the first electrode 11, the organic layer 12, and the second electrode 13. Glass, plastic, silicon, or the like can be used, for example. Switching elements such as transistors, interconnects, and interlayer insulating films, and the like (not shown) may be disposed in the substrate 8.

The first electrode 11 may be transparent or opaque. If opaque, a metal material having a reflectance of at least 70% at the light emission wavelength is desirable. Metals such as Al and Ag, alloys having Si, Cu, Ni, Nd, or the like added thereto, as well as ITO, IZO, AZO, or IGZO can be used. Here, light emission wavelength refers to the spectral range emitted from the organic layer 12. The first electrode 11 may be a layered electrode having a barrier electrode formed from a metal such as Ti, W, Mo, Au, or an alloy thereof, or a layered electrode including a transparent oxide film electrode such as ITO or IZO, as long as the reflectance is higher than desired.

On the other hand, if the first electrode 11 is a transparent electrode, the configuration may be such that a reflective layer is further provided below the first electrode 11. ITO, IZO, AZO, and IGZO can be used as the transparent electrode, for example. For the purpose of optimizing the optical distance, another insulating film may further be provided between the reflective layer and the transparent electrode.

The second electrode 13 is disposed on the organic layer 12, and is light-transmissive. The second electrode 13 may be a semi-transparent material that has a property of transmitting some of the light reaching the surface thereof and reflecting the rest (i.e., semi-transmissive reflectivity). A transparent material, such as a transparent conductive oxide, can be used as the material of the second electrode 13, for example. A semi-transparent material formed from a single metal such as aluminum, silver, and gold, an alkali metal such as lithium and cesium, an alkali-earth metal such as magnesium, calcium, and barium, and alloy materials containing these metal materials can be used. Alloys based on magnesium or silver are particularly preferable as the primary component of the semi-transparent material. The second electrode 13 may have a layered configuration including layers of the above materials as long as the preferred transmittance is achieved. The second electrode 13 may be shared by a plurality of light-emitting elements 10.

One of the first electrode 11 or the second electrode 13 functions as the anode, and the other as the cathode. In other words, the first electrode 11 may be the anode and the second electrode 13 the cathode, or vice versa. The organic layer 12 is disposed on the first electrode 11 and can be formed through publicly-known techniques such as vapor deposition and spin coating.

The organic layer 12 may be constituted by a plurality of layers. When the organic layer 12 is an organic compound layer, any one or a combination of the following can be given as the plurality of layers: a hole injection layer, a hole transport layer, an electron blocking layer, a light-emitting layer, a hole blocking layer, an electron transport layer, and an electron injection layer.

The light-emitting layer emits light when holes injected from the anode and electrons injected from the cathode recombine in the organic compound layer. The light-emitting layer may be constituted by a single layer or a plurality of layers. Each light-emitting layer can have a red light-emitting material, a green light-emitting material, and a red light-emitting material, and it is also possible to obtain white light by mixing the light emission colors. Each of the light-emitting layers may also contain light-emitting materials in complementary color relationships, such as a blue light-emitting material and a yellow-light emitting material. The light-emitting materials may be fluorescent materials, phosphorescent materials, delayed fluorescent materials, or the like, or may be quantum dots such as CdS or perovskite. Different colors may also be emitted by changing the materials and composition of the light-emitting layers in each pixel. Light-emitting layers may also be provided one-to-one for the light-emitting elements 10. In this case, the light-emitting layer may be patterned for each of the light-emitting elements 10.

The protective layer 14 is an insulating layer and preferably contains an inorganic material that is light-transmissive and has low permeability to oxygen and moisture from the outside. For example, the protective layer 14 can be formed using an inorganic material such as silicon nitride (SiN), silicon oxynitride (SiON), silicon oxide (SiOx), aluminum oxide ($Al_2O_3$), titanium oxide ($TiO_2$), or the like. Inorganic materials such as SiN, SiON, and $Al_2O_3$ are particularly preferable in terms of protective performance. Chemical vapor deposition (CVD), atomic layer deposition (ALD), or sputtering is preferable to use to form the protective layer 14.

The protective layer 14 may have a single-layer structure or a layered structure combining the above materials and formation techniques, as long as the layer has sufficient moisture blocking performance. For example, a layer of silicon nitride, and a high-density layer formed by atomic deposition, may be used. Furthermore, the protective layer 14 may have an organic layer, as long as the moisture blocking performance is maintained. Organic layers include, for example, polyacrylate, polyimide, polyester, epoxy, and the like. Furthermore, the protective layer 14 may be disposed across a plurality of the light-emitting elements 10. A planarization layer may be formed between the protective layer 14 and the microlenses 15 for the purpose of eliminating unevenness in the protective layer 14. A color filter may be disposed between microlens 15 and the protective layer 14 or between the microlens 15 and the planarization layer.

The microlenses 15 can be formed by an exposure and development process. Specifically, a film (a photoresist film) is formed from the material used to form the microlenses, and the photoresist film is exposed and developed using a mask in which the gradation changes continuously. A gray mask, or an area gradation mask that allow continuous gradation of light exposure on the image forming surface by varying the density distribution of dots formed from a light shielding film at a resolution less than or equal to that of the exposure device, can be used as the mask.

The lens shape can be adjusted by etching back the microlenses formed by the exposure and development process. The shape of the microlens may be spherical, or asymmetric in terms of the cross-sectional shape, as long as the shape is capable of refracting radiated light.

Effects of the present embodiment will be described next using the example of a light-emitting element having convex microlenses on the side opposite from the substrate. The effects of the present embodiment are independent of the direction of the convex shape of the microlenses. In other words, microlenses having a convex shape in the downward direction in the drawing, as illustrated in FIG. 3C, may be used.

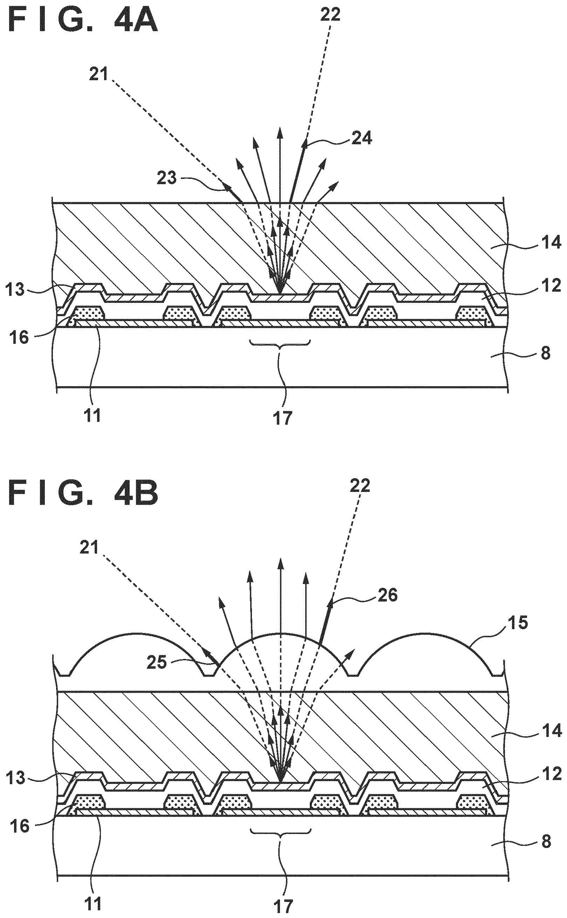

FIGS. 4A to 4C are cross-sectional views of the edge region 2 when cut along the A-A' line in FIG. 2. FIGS. 4A and 4B illustrate a configuration in which the microlenses 15 are not disposed, and a configuration in which the microlenses 15 and the light emission regions 17 are disposed so as to overlap without being shifted in plan view, respectively.

In FIG. 4A, a radiation angle (angle of radiation) 21 represents the radiation angle of the main light rays of normal light in the air, and a radiation angle 22 represents the radiation angle of ghost light in the air. The normal light is light that passes through the optical path designed according to the lens design and forms an image in the observer's pupil. The main light rays are the light, of the normal light, that passes through the center of the observer's pupil. In an ocular optical system that bends the optical path, the focal length is shortened, and thus the radiation angle of the main light rays of normal light in the air increases at the edge of the display region 1, as illustrated in FIG. 4A.

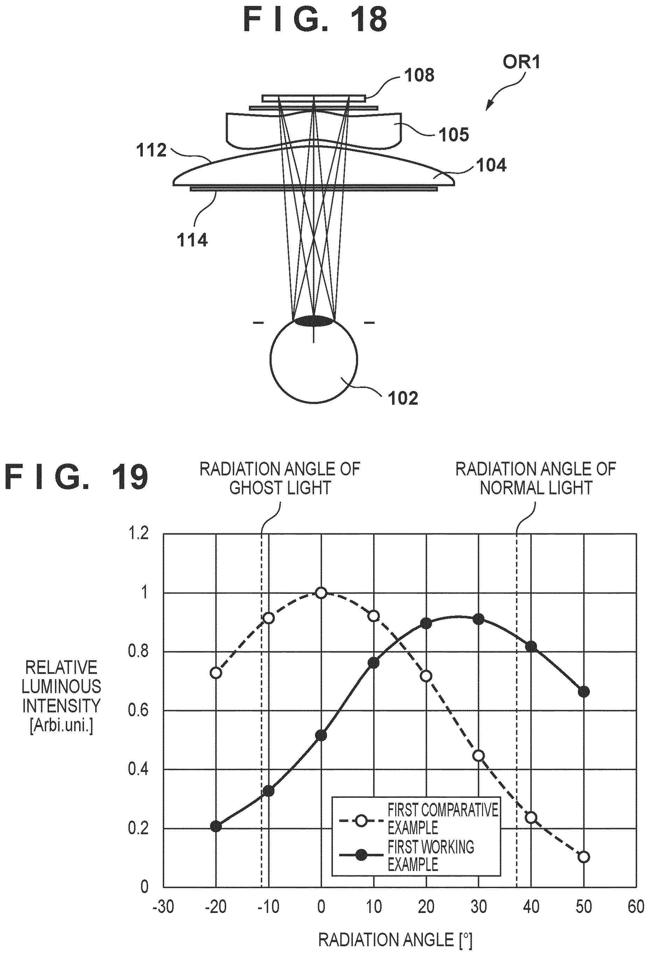

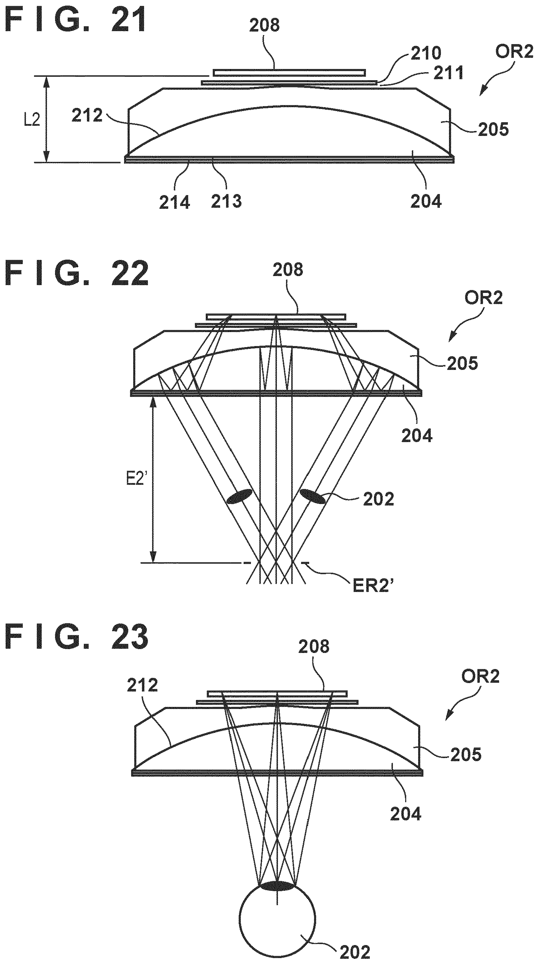

On the other hand, ghost light is light that is emitted from a light-emitting element and passes through an optical path not intended by the design, and is observed as ghosting by the observer. In general, the optical path of ghost light is roughly determined by the positional relationship between the light-emitting elements of the display region 1 and the observer's pupil, as illustrated in FIGS. 18 and 23. In such a case, as illustrated in FIG. 4A, the radiation angle decreases, and the direction thereof is opposite from the direction of the normal light with respect to the normal direction of the main surface of the substrate.

FIG. 4A illustrates the light emitted from the light-emitting element 10 when no microlens is provided. The directions of the vectors (arrows) represent the directions in which the light travels, and the magnitudes of the vectors represent the intensity of the radiated light. In general, light-emitting elements have radiation angle dependence, such that the wider the angle is, the lower the radiation intensity becomes. Accordingly, when no microlenses are provided, light 23 emitted in the direction of the radiation angle 21 of the main light rays of the normal light is weaker than radiated light 24 emitted in the direction of the radiation angle 22 of the ghost light. In other words, at the edges of the display region 1, the optical intensity of the light emitted from the light-emitting element is stronger for ghost light than for normal light. The same applies when the microlens 15 and light emission region 17 are disposed so as to overlap in plan view, as illustrated in FIG. 4B, with light 25 emitted in the direction of the radiation angle 21 of the main light rays of normal light being weaker than radiated light 26 emitted in the direction of the radiation angle 22 of the ghost light.

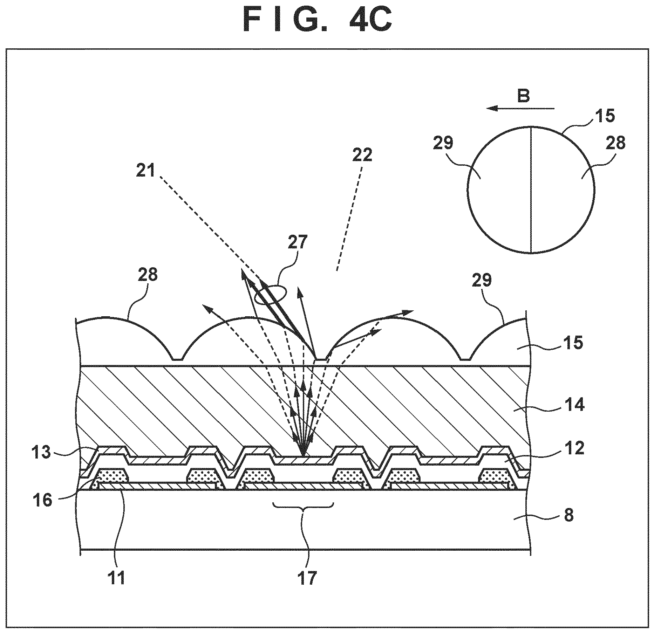

FIG. 4C illustrates the present embodiment, where the microlens 15 and the light emission region 17 are shifted by a given distance. By shifting the microlens 15 in the direction indicated by the arrow B with respect to the light emission region 17, light is refracted through a surface 28 of the microlens 15, which dramatically increases the intensity of light 27 emitted in the direction of the radiation angle 21 of the main light rays of the normal light. At the same time, the intensity of the ghost light in the direction of the radiation angle 22 is significantly reduced. This is due to the fact that the ghost light is mainly refracted to the wide-angle side at the surface 29 of the adjacent microlens 15, or is confined within the microlens by total reflection. Here, the surface 28 and the surface 29 refer to surfaces in the opposite direction and the forward direction of the arrow B, respectively, taking as a boundary the plane passing through the center of the microlens 15 and orthogonal to the direction of the arrow B, as indicated in the upper-right part of FIG. 4C, which is a plan view of the microlens 15 in FIG. 4C.

By disposing the microlens 15 and the light emission region 17 shifted by a given distance, it is possible not only to increase the luminous intensity of the normal light at the edges of the display region 1, but also to reduce ghost light at the same time.

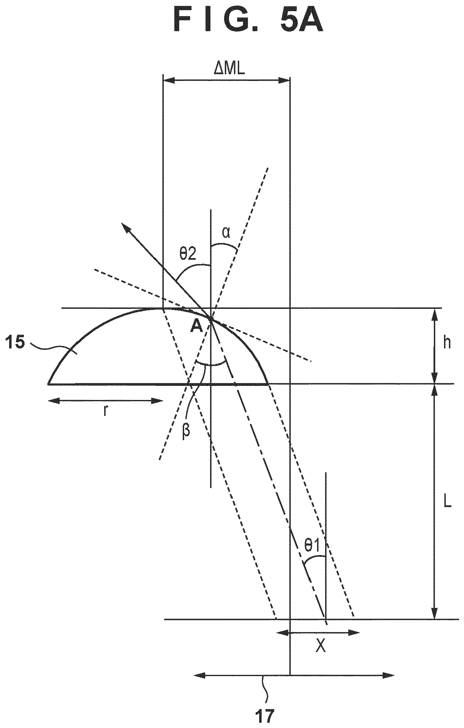

FIG. 5A is a cross-sectional view illustrating the relationship between the light emission region 17, the microlens 15, and the normal light emission angle. In FIGS. 5A to 5C, a microlens 15 having a height h, a radius r, and refractive index n is disposed.

Light is emitted from the light emission region 17 at an angle $\theta 1$ and is bent in the direction of an angle $\theta 2$ at a point A on the microlens 15. Here, the tilt of the normal line of the microlens surface at the point A relative to the normal line of the substrate 8 at this time is an angle $\alpha$. Assuming that $\alpha + \theta 1$ is $\beta$, the following Formula (1) is established, according to Snell's law.

$$1 \times \sin(\theta 2 + \alpha) = n \times \sin\beta = n \times \sin(\theta 1 + \alpha) \qquad ...(1)$$

By solving Formula (1) for $\theta 1$, $\theta 1$ is expressed by Formula (2).

$$\theta 1 = \sin^{-1}\{\sin(\theta 2 + \alpha)/n\} - \alpha \qquad ...(2)$$

As illustrated in FIG. 5A, when light is to be emitted from the light emission region 17 to the wide-angle side ($\theta 2 > \theta 1$), the light incident on the region where $\alpha$ is positive, i.e., the region to the right of the apex of the microlens 15 in FIG. 5A, or in other words, the surface 28, will mainly be used.

In order to effectively use the microlens 15 to the edge thereof, it is desirable that $\alpha < \theta 2$ in the entire region of the microlens 15 with respect to the radiation angle $\theta 2$ of the main light rays of normal light.

Here, assume that $\Delta ML$ is the amount of shift of the apex of the microlens 15 from the center of the light emission region 17. To increase the emission intensity at the desired emission angle $\theta 2$, $\theta 1$ and $\beta$ satisfying the above Formula (2) may be calculated for $\alpha$ at each of points on the microlens 15, and $\Delta ML$ may be set such that a light emission region X is present in either β direction. In other words, as the ratio of the light emission region X to the light emission region 17 illustrated in FIG. 5A increases, so too does the optical intensity of the normal light.

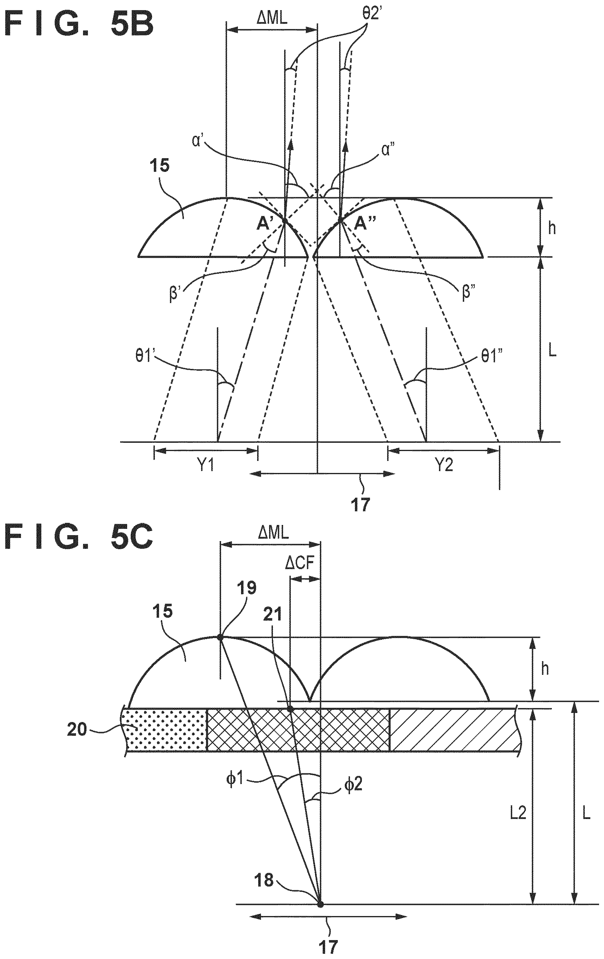

On the other hand, FIG. 5B is a cross-sectional view illustrating the relationship between the light emission region 17, the microlens 15, and the ghost light emission angle. Light is emitted from the light emission region at an angle θ1' and an angle θ1", and the light is bent in the direction of an angle θ2' at a point A' and point A" on the microlens, respectively. Here, the tilts of the normal line of the microlens surface at the point A and the point A" relative to the normal line of the substrate 8 at this time are angles α' and α", respectively. As in the case of normal light, θ1' and θ1" are expressed by Formula (3) and Formula (4).

$$\theta'1 = \sin^{-1}\{\sin(\theta2' + \alpha')/n\}\text{-}\alpha' \qquad ...(3)$$

$$\theta''1 = \sin^{-1}\{\sin(\theta2' + \alpha'')/n\}\text{-}\alpha'' \qquad ...(4)$$

To reduce the emission intensity of the light at the emission angle θ2', which is ghost light, it is desirable that light emission regions Y1 and Y2 do not overlap with the light emission region 17. Specifically, θ1' and θ1" obtained from Formulas (3) and (4) may be increased. This is because increasing θ1' and θ1" reduces the optical intensity of light emitted from the light-emitting element. When a given critical angle is exceeded, total reflection occurs internally and light does not reach the microlens.

In this manner, the shift amount ΔML may be determined such that the light emission region X from which normal light is emitted is large with respect to the light emission region 17, and the light emission regions Y1 and Y2 in which light is emitted in the direction that produces ghost light are small. In the present embodiment, the shape of the opening may be optimized as appropriate, and the shape may be circular, hexagonal, elliptical, or the like. For example, the shape of the opening in the light-emitting pixel may be formed such that X is larger and Y1 and Y2 are smaller.

As illustrated in FIG. 5C, it is desirable that the range of the shift amount ΔML at the edge 2 of the display region 1 (see FIG. 1) satisfies the following Formula (5), assuming the height of the microlens 15 is represented by h, the height from the first electrode 11 to the bottom surface of the microlens 15 is represented by L, and the tilt angle, relative to the normal direction of the substrate 8, of a straight line connecting the center position 19 of the microlens 15 and the center position 18 of the light emission region 17 is represented by φ1 = arctan(ΔML/(h + L)) [degrees].

$$6.0° \le \phi1 \le 37.5° \qquad ...(5)$$

A shift amount ΔCF of the color filter will be described next. When the organic layer 12 is constituted by a layer that emits white light, the color filter 20 may be provided between the light-emitting element 10 and the microlens 15, as illustrated in FIG. 3B. It is desirable that the range of ΔCF at the edge 2 of the display region 1 satisfies Formula (6), assuming the height from the first electrode 11 to the top surface of the color filter 20 is represented by L2, the tilt angle, relative to the normal direction of the substrate 8, of a straight line connecting a center position 21 of the top surface of the color filter 20 and the center position 18 of the light emission region 17 is represented by φ2 = arctan(ΔCF/L2) [degrees], and a ratio A of φ1 and φ2 is A = φ2/φ1.

$$0 \le A \le 0.85 \qquad ...(6)$$

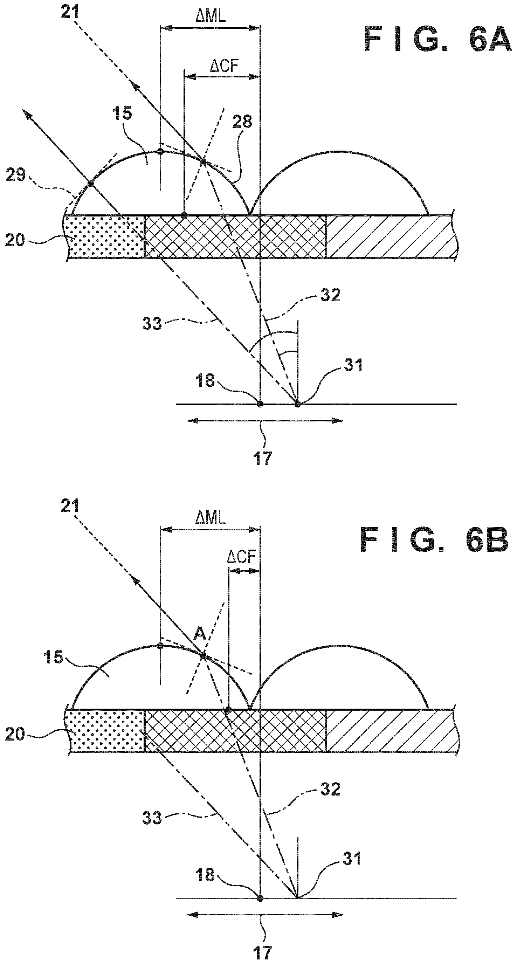

FIGS. 6A and 6B are cross-sectional views illustrating the positional relationship between the light emission region 17 and the microlens 15 at the edge 2 of the display region 1, and illustrate a component emitted in the direction of the radiation angle 21 of normal light. FIG. 6A illustrates a case where A = 1 as an example where Formula (6) is not satisfied. As described with reference to FIG. 5A, the light emitted in the direction of the radiation angle 21 of normal light is mainly radiated light 32 through the surface 28 of the microlens 15, but there is some radiated light 33 which passes through the surface 29. The luminous intensity of the radiated light 33 is lower than the luminous intensity of the radiated light 32 due to the large radiation angle from the normal direction of the substrate 8. However, because of the large radiation angle, the degree of color shift in the radiated light 33 is greater than in the radiated light 32. Therefore, as illustrated in FIG. 6A, if the color filter 20 is shifted by the same proportion (A = 1) as the microlens 15, the color shift increases due to the radiated light 33. The color shift is the difference between the chromaticity in the normal direction of the substrate 8 at the center of the display region 1 and the chromaticity of the radiated light emitted from the edge 2 of the display region 1 in the direction of the radiation angle 21.

On the other hand, FIG. 6B is a cross-sectional view illustrating the positional relationship between the light emission region 17 and microlens 15 at the edge 2 of the display region 1 when Formula (6) is satisfied. As can be seen from FIG. 6B, reducing the shift amount ΔCF makes it possible to block the radiated light 33, which has a high degree of color shift, using the color filter, which makes it easier to suppress color shift. Although details will be given later, by optimizing the shift amounts ΔML and ΔCF as appropriate, color shift can be suppressed while also suppressing the luminous intensity of ghost light.

However, when a color filter is disposed above a microlens having a convex shape in the downward direction in the drawing, as illustrated in FIG. 3C, it is not necessary for the relational expression in Formula (6) to be satisfied, and A = 1 may be used. This is because the radiated light 33 emitted on the wide-angle side illustrated in FIG. 6B is totally reflected by the low-refractive index medium between the protective layer and the microlens, and therefore does not reach the microlens.

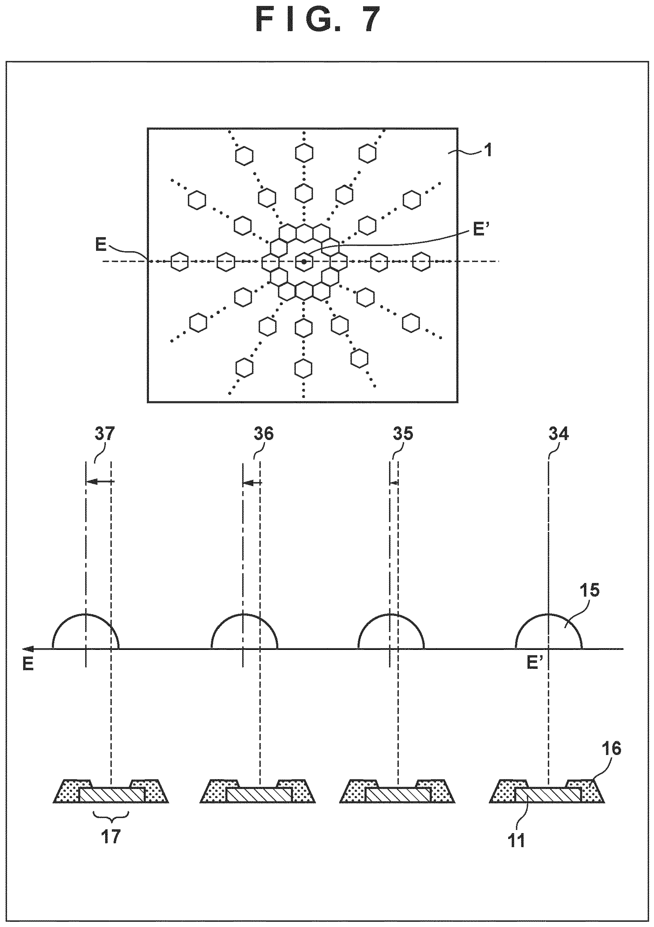

In the present embodiment, the shift amount ΔML at each position in the display region 1 is adjusted as appropriate in accordance with the design of the ocular optical system. FIG. 7 is a cross-sectional view of the display region 1 cut along a line E-E', and illustrates the positional relationship between the microlens 15 and the light emission region 17. Here, as before, an example of a light-emitting element having convex microlenses on the side opposite from the substrate will be described. The effects of the present embodiment are independent of the direction of the convex shape of the microlenses. In other words, microlenses having a convex shape in the downward direction in the drawing, as illustrated in FIG. 3C, may be used.

As illustrated in FIG. 7, the microlens 15 may be disposed such that the shift amount ΔML (34) is 0 at the center position of the display region 1, and the shift amount ΔML increases toward the edge of the display region 1, as indicated by ΔML (35), ΔML (36), and ΔML (37). As illustrated in FIGS. 18 and 23, the amount of ghost light is mainly determined by the linear relationship between the position of the light-emitting element 17 in the display region 1 and the pupil of the observer. As such, the shift amount ΔML (34) to ΔML (37) may increase linearly as a function of the position of the light-emitting element 17. The shift amount ΔML may be formed so as to vary continuously in macroscopic view with respect to the position of the light-emitting element 17. The shift amount may be varied per pixel, or may be varied stepwise over a given range, as long as the shift amount varies continuously in macroscopic view. The shift amount may be varied one pixel at a time in a given range, and may be varied in a stepwise manner in the remaining ranges. However, if the focal length is reduced, the aspheric shape of the lens surface closer to the display element 100 may change more, and the rate of change in the radiation angle of the ghost light may increase closer to the edge of the display region 1. In such cases, the rate of change in the shift amount ΔML may be increased to match the rate of change in the radiation angle of the ghost light. FIG. 7 illustrates a case where the shift amount ΔML (34) at the center of the display region 1 is 0 is illustrated, but the shift amount does not necessarily have to be 0. The shift amount ΔML may be made uniform and constant in the display region 1.

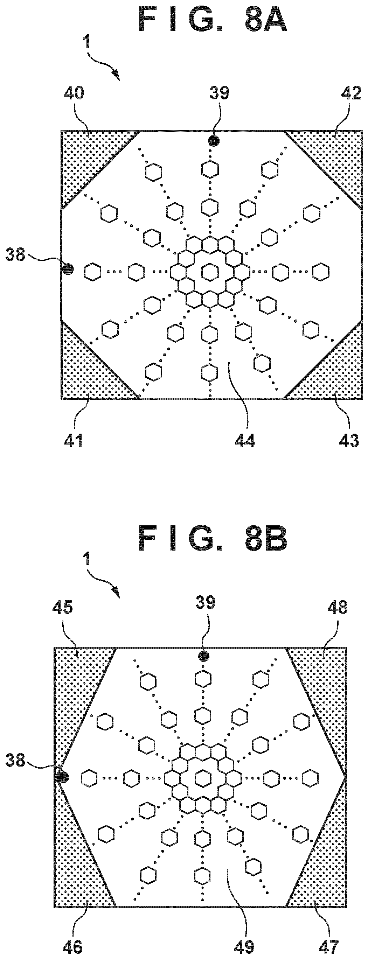

In an image observation apparatus having an ocular optical system, the value of the shift amount ΔML is designed such that the viewing angle characteristics at a horizontal edge 38 or a vertical edge 39 in FIGS. 8A and 8B are best when the shift amount ΔML increases toward the edge of the display region 1, as illustrated in FIG. 7. In such a case, in diagonal regions 40, 41, 42, and 43 in FIG. 8A, the shift amount ΔML may be a value close to the pitch D of the light-emitting elements, and the luminous intensity of ghost light may be high. In such a case, as illustrated in FIG. 8A, the light-emitting elements may not be disposed in at least one of the diagonal regions 40, 41, 42, and 43 in the display region 1.

If light-emitting elements are not disposed in all the diagonal regions, the display region becomes an octagon (an n-polygon), as indicated by a region 44. If light-emitting elements are not disposed only in the diagonal regions 40 and 42, the display region becomes a hexagon constituted by regions 41, 43, and 44. As in FIG. 8A, one or both of the light-emitting elements and microlenses may not be disposed in at least one of diagonal regions 45, 46, 47, and 48 in FIG. 8B. In other words, if light-emitting elements are not disposed in all the diagonal regions, the display region becomes a hexagon, as indicated by a region 49. Microlenses may or may not be disposed in regions where light-emitting elements are not disposed. The arrangement of the light-emitting elements and microlenses in the present embodiment may be adjusted as appropriate according to the optical design, and the configuration may be such that light-emitting elements are disposed in the diagonal regions and only the microlenses are not disposed.

Alternatively, the shift amount ΔML of the microlens in the diagonal regions 40, 41, 42, and 43 (or 45, 46, 47, and 48) may be kept constant, and kept consistent with the shift amount at the edge 38 or the edge 39, so as not to exceed the shift amount ΔML of the microlens at the horizontal edge 38 and the vertical edge 39.

As described above, by shifting the light emission region 17 and the microlens 15 in the direction parallel to the main surface of the substrate 8 at the edge of the display region 1, the luminous intensity of the normal light of the ocular optical system, which bends the optical path, can be increased, and ghosting can be reduced.

Several embodiments illustrating that the above-described display element is effective in various ocular optical systems that bend the optical path will be described next. The first embodiment and a second embodiment describe examples of application in a polarizing optical system which uses polarized light. A third embodiment will describe an example of application in a freeform prism. In addition, desirable configurations of the ocular optical system that bends the optical path will also be described in each embodiment. Each of the embodiments described here is only a representative example, and many variations and changes can be made to each of the embodiments when carrying out the present invention.

The configuration of a display device according to the present embodiment will be described here.

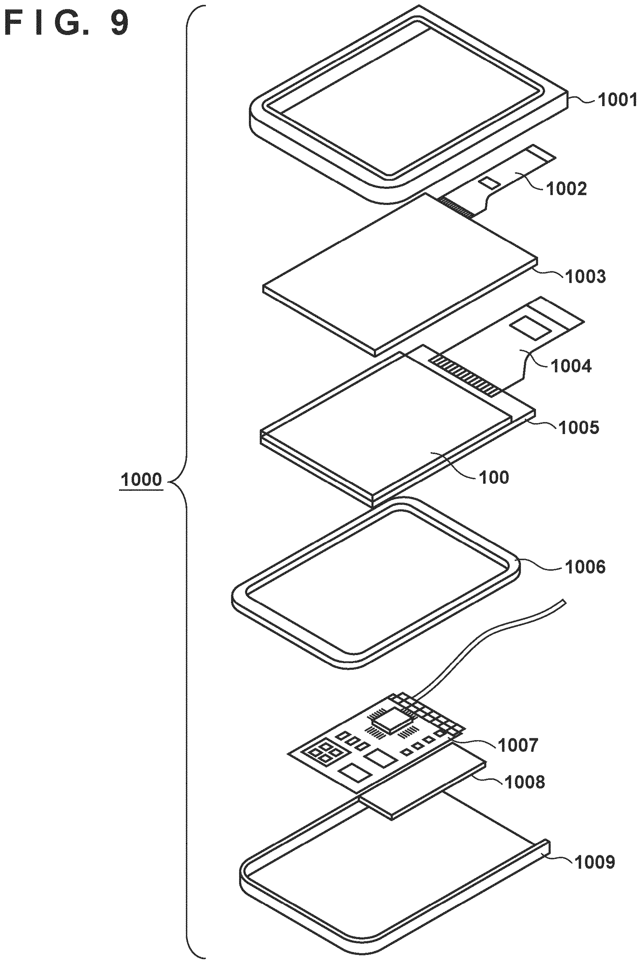

FIG. 9 is a schematic diagram illustrating an example of the display device according to the present embodiment. A display device 1000 may have a touch panel 1003, a display panel 1005 including the display element 100, a frame 1006, a circuit board 1007, and a battery 1008 provided between a top cover 1001 and a bottom cover 1009. The touch panel 1003 and the display panel 1005 are connected to flexible printed circuit FPCs 1002 and 1004. Transistors are printed on the circuit board 1007. The battery 1008 need not be provided if the display device is not a portable device, or may be provided in a different location even if the display device is a portable device.

The display device according to the present embodiment may have color filters with red, green, and blue colors. The color filters may be disposed with the red, green, and blue colors arranged in a delta array.

The display device according to the present embodiment may be used in a display unit of a mobile terminal. In this case, both a display function and an operation function may be provided. A mobile telephone such as a smartphone, a tablet, a head-mounted display, and the like can be given as examples of mobile terminals.

The display device according to the present embodiment may be used as a display unit in an image capturing device including an optical unit having a plurality of lenses and an image sensor that receives light passing through the optical unit. The image capturing device may have a display unit that displays information obtained by the image sensor. The display unit may be a display unit that is exposed to the exterior of the image capturing device, or a display unit disposed within a viewfinder. The image capturing device may be a digital camera or a digital video camera.

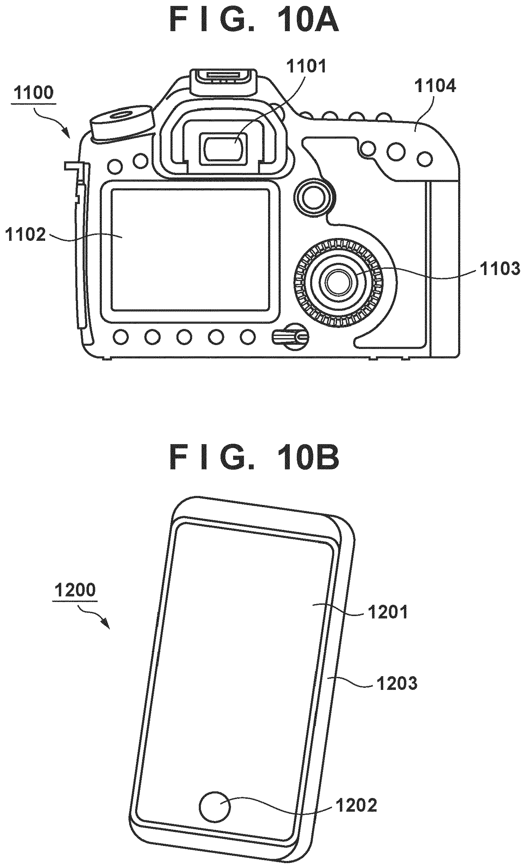

FIG. 10A is a schematic diagram illustrating an example of the image capturing device according to the present embodiment. An image capturing device 1100 may include a viewfinder 1101, a rear display 1102, an operation unit 1103, and a housing 1104. The viewfinder 1101 may have the display device according to the present embodiment. In this case, the display device may display not only images to be captured, but also environmental information, image capturing instructions, and the like. The environmental information may include the intensity of ambient light, the direction of ambient light, a speed at which a subject is moving, the likelihood that the subject will be blocked by an obstruction, and the like.

Because the optimal timing for capturing an image is very short, it is better to display the information as quickly as possible. It is therefore preferable to use a display device that uses the organic light-emitting element of the present invention. This is because organic light-emitting elements have a high response speed. In such devices which require high display speeds, a display device using an organic light-emitting element can be used more favorably than a liquid crystal display device.

The image capturing device 1100 includes an optical unit, which is not shown. The optical unit has a plurality of lenses, and an image is formed on the image sensor, which is contained within the housing 1104. The focal point can be adjusted by adjusting the relative positions of the plurality of lenses. This operation can also be performed automatically. The image capturing device may be called a photoelectric conversion device. Rather than sequentially capturing images, the photoelectric conversion device can include image capturing methods such as a method that detects a difference from a previous image, a method that cuts out from an image that is continuously recorded, and the like.

FIG. 10B is a schematic diagram illustrating an example of an electronic device according to the present embodiment. An electronic device 1200 has a display unit 1201, an operation unit 1202, and a housing 1203. Circuits, a printed circuit board including the circuits, a battery, and a communication unit may be provided within the housing 1203. The operation unit 1202 may be a button, or may be a touch panel-type reactive part. The operation unit may be a biometric recognition unit that unlocks the device by recognizing a fingerprint or the like. An electronic device having a communication unit can also be called a communication device. The electronic device may further include a lens and an image sensor to provide a camera function. An image captured by the camera function is displayed in the display unit. A smartphone, a laptop computer, and the like can be given as examples of electronic devices.

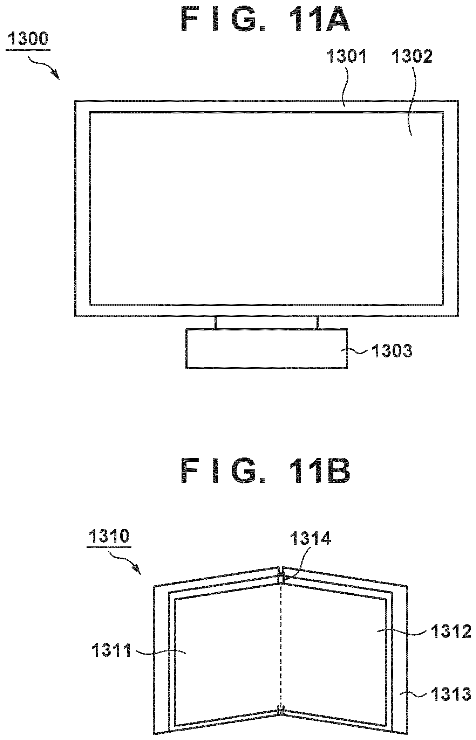

FIGS. 11A and 11B are schematic diagrams illustrating examples of the display device according to the present embodiment. FIG. 11A illustrates a display device such as a television monitor, a PC monitor, or the like. A display device 1300 has a frame 1301, as well as a display unit 1302. The light-emitting device according to the present embodiment may be used in the display unit 1302.

The frame 1301, as well as a base 1303 that supports the display unit 1302, are provided. The base 1303 is not limited to the form illustrated in FIG. 11A. The bottom edge of the frame 1301 may serve a dual function as a base.

The frame 1301 and the display unit 1302 may also be curved. The curvature radius thereof may be at least 5000 mm and at most 6000 mm.

FIG. 11B is a schematic diagram illustrating another example of the display device according to the present embodiment. A display device 1310 illustrated in FIG. 11B is what is known as a foldable display device, in which the display surface is configured to be capable of folding. The display device 1310 has a first display unit 1311, a second display unit 1312, a housing 1313, and a folding point 1314. The first display unit 1311 and the second display unit 1312 may have the light-emitting device according to the present embodiment. The first display unit 1311 and the second display unit 1312 may be a single display device that does not have a joint. The first display unit 1311 and the second display unit 1312 can be separated at the folding point. The first display unit 1311 and the second display unit 1312 may display different images, or a single image may be displayed across the first and second display units.

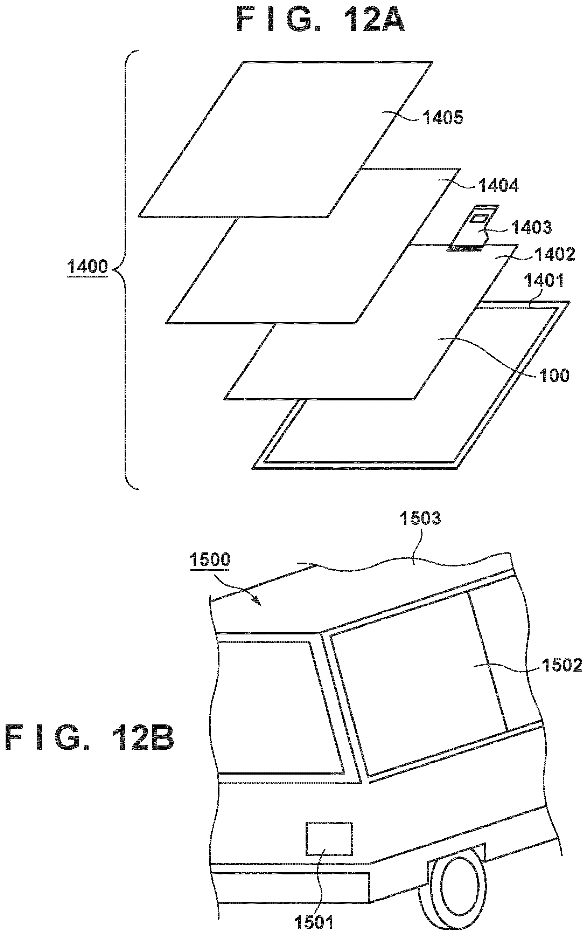

FIG. 12A is a schematic diagram illustrating an example of a lighting device according to the present embodiment. A lighting device 1400 may have a housing 1401, a light source 1402 including the display element 100, a circuit board 1403, an optical filter 1404, and a light diffusing unit 1405. The light source may have the organic light-emitting element according to the present embodiment. The optical filter may be a filter that improves the color rendering properties of the light source. The light diffusing unit can effectively diffuse light from the light source, such as lighting or the like, and deliver the light over a broad area. The optical filter and the light diffusing unit may be provided on the light emission side of the lighting. A cover may be provided on the outermost part as necessary.

The lighting device is, for example, a device that illuminates a room. The lighting device may emit light which is white, daylight color, or any other color from blue to red. A dimming circuit that dims the light may be provided as well. The lighting device may have the organic light-emitting element of the present invention and a power supply circuit connected thereto. The power supply circuit is a circuit that converts AC voltage into DC voltage. White has a color temperature of 4200 K, and daylight color has a color temperature of 5000 K. The lighting device may have a color filter.

The lighting device according to the present embodiment may also have a heat dissipation unit. The heat dissipation unit dissipates heat from inside the device to outside the device, and a metal having a high specific heat, liquid silicon, and the like can be given as examples thereof.

FIG. 12B is a schematic diagram illustrating an automobile serving as an example of a moving body according to the present embodiment. The automobile has a tail lamp, which is an example of a lighting fixture. An automobile 1500 has a tail lamp 1501, and may turn on the tail lamp when a braking operation or the like is performed.

The tail lamp 1501 may have the organic light-emitting element according to the present embodiment. The tail lamp may have a protective member that protects the organic EL element. The protective member may be formed from any material which has a certain degree of strength and is transparent, but is preferably formed from polycarbonate or the like. The polycarbonate may be mixed with a furandicarboxylic acid derivative, an acrylonitrile derivative, or the like.

The automobile 1500 may have a vehicle body 1503 and a window 1502 attached thereto. The window may be a transparent display, as long as that window is not used to check the front and rear of the automobile. The transparent display may have the organic light-emitting element according to the present embodiment. In this case, the materials constituting the electrodes and the like of the organic light-emitting element are constituted by transparent members.

The moving body according to the present embodiment may be a ship, an aircraft, a drone, or the like. The moving body may have a fuselage and a lighting fixture provided in the fuselage. The lighting fixture may emit light for indicating the position of the fuselage. The lighting fixture has the organic light-emitting element according to the present embodiment.

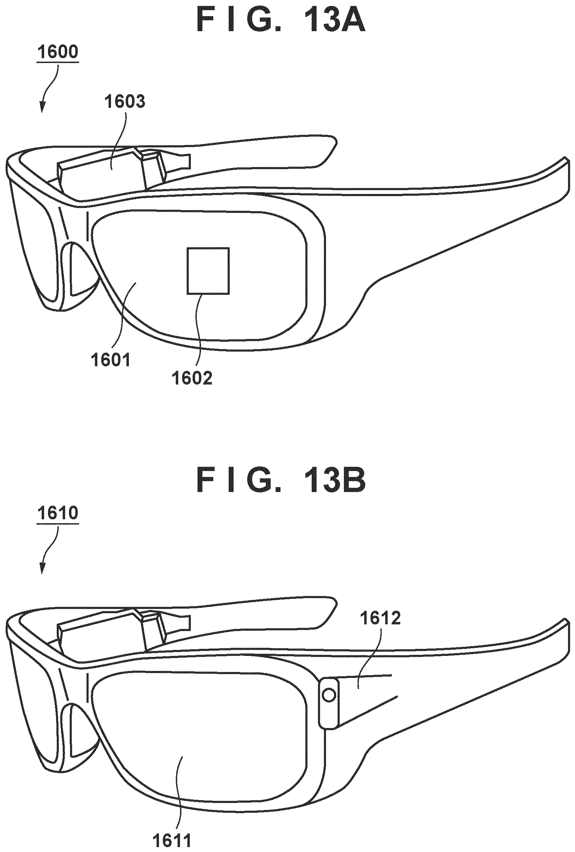

FIGS. 13A and 13B are schematic diagrams illustrating an eyeglass-type display device, which is an example of a wearable device in which the light-emitting device according to an embodiment of the present invention is applied. The display device can be applied in a system that can be worn as a wearable device, such as smart glasses, an HMD, or smart contacts, for example. An image capturing/display device used in such an application example may have an image capturing device capable of photoelectrically converting visible light, and a display device capable of emitting visible light.

FIG. 13A illustrates eyeglasses 1600 (smart glasses) according to one application example. An image capturing device 1602 such as a CMOS sensor or a SPAD is provided on a front surface side of a lens 1601 of the eyeglasses 1600. The display device of the above-described embodiments is provided on a rear surface side of the lens 1601.

The eyeglasses 1600 are further provided with a control device 1603. The control device 1603 functions as a power supply that supplies power to the image capturing device 1602 and the display device according to the embodiments. The control device 1603 also controls the operations of the image capturing device 1602 and the display device. An optical system for focusing light onto the image capturing device 1602 is formed in the lens 1601.

FIG. 13B illustrates eyeglasses 1610 (smart glasses) according to one application example. The eyeglasses 1610 have a control device 1612, and the control device 1612 includes an image capturing device corresponding to the image capturing device 1602 and a display device. An optical system for projecting light emitted from the image capturing device and the display device within the control device 1612 is formed in a lens 1611, and an image is projected onto the lens 1611. The control device 1612 functions as a power supply that supplies power to the image capturing device and the display device, and also controls the operations of the image capturing device and the display device. The control device may include a gaze detection unit that detects a wearer's gaze. Infrared light may be used for the gaze detection. An infrared light emission unit emits infrared light toward the eyeball of a user gazing at the displayed image. Of the emitted infrared light, reflected light from the eyeball is detected by an image capturing unit having a light-receiving element, and a captured image of the eyeball is obtained. Providing a reduction means that reduces the light from the infrared light emission unit to the display unit in plan view reduces a drop in the image quality.

The user's gaze with respect to the displayed image is detected from the captured image of the eyeball obtained from capturing the image of infrared light. Any publicly-known method can be used for the gaze detection using a captured image of the eyeball. For example, a gaze detection method based on a Purkinje image produced by the reflection of irradiation light at the cornea can be used.

More specifically, gaze detection processing is performed based on a pupil-corneal reflection method. Using the pupil-corneal reflection method, the user's gaze is detected by calculating a gaze vector, which represents the orientation (rotation angle) of the eyeball, based on an image of the pupil and a Purkinje image in the captured image of the eyeball.

A display device according to one embodiment of the present invention may have an image capturing device having a light-receiving element, and may control images displayed by the display device based on gaze information of the user from the image capturing device.

Specifically, based on the gaze information, a first visual field region at which the user gazes and a second visual field region outside the first visual field region are determined in the display device. The first visual field region and the second visual field region may be determined by the control device of the display device, or regions determined by an external control device may be received. In the display region of the display device, the display resolution of the first visual field region may be controlled to be higher than the display resolution of the second visual field region. In other words, the resolution of the second visual field region may be lower than that of the first visual field region.

Additionally, the display region has a first display region and a second display region that is different from the first display region, and a region having a higher priority is determined from the first display region and the second display region based on the gaze information. The first visual field region and the second visual field region may be determined by the control device of the display device, or regions determined by an external control device may be received. The resolution of the higher-priority region may be controlled to be higher than the resolution of regions aside from the higher-priority region. In other words, the resolution may be lowered for regions of relatively low priority.

Note that AI may be used to determine the first visual field region, the higher-priority region, and the like. The AI may be a model configured to estimate the angle of the gaze and a distance to an object being gazed upon from an image of an eyeball, using images of eyeballs and the directions in which the eyeballs in those images are actually gazing as supervisory data. An AI program may be held in the display device, in the image capturing device, or in an external device. If held in an external device, the program may be provided to the display device through communication.

When controlling the display based on gaze detection, the present invention can be preferably applied in smart glasses that further included an image capturing device that captures images of the exterior. The smart glasses can display the captured outside information in real time.

As described thus far, using a device which uses the organic light-emitting element according to the present embodiment makes it possible to achieve a stable display over long periods of time with good image quality.

An example in which the display element of the present embodiment is combined with an ocular optical system that bends the optical path will be described next.

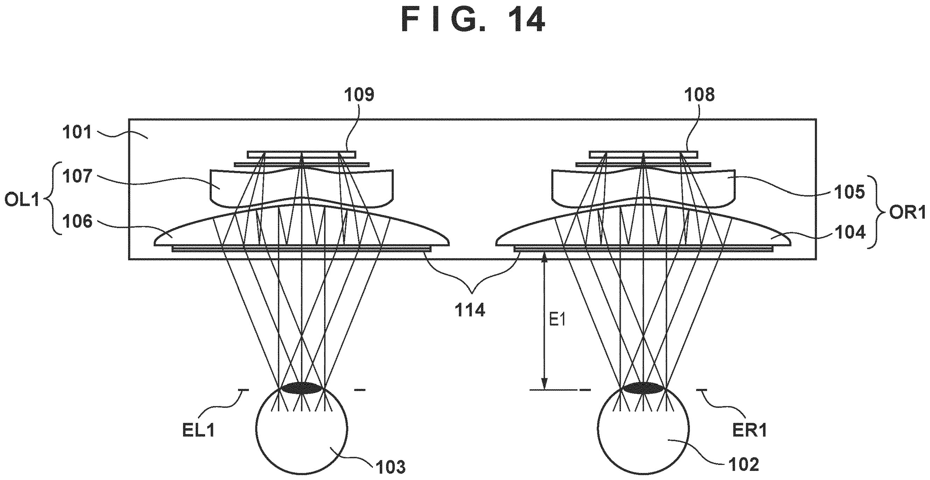

FIG. 14 is a diagram illustrating the configuration of a head-mounted display (HMD) 101 serving as an image observation apparatus of the present embodiment. The HMD 101 is worn on the head of an observer. Reference sign 102 indicates the right eye of the observer, and reference sign 103 indicates the left eye of the observer. Display lenses 104 and 105 constitute a right eye ocular optical system OR1, and display lenses 106 and 107 constitute a left eye ocular optical system OL1. Each ocular optical system is a coaxial optical system constituted by a plurality of (two) display lenses. The right eye 102 of the observer is located at an exit pupil ER1 of the right eye ocular optical system OR1, and the left eye 103 of the observer is located at an exit pupil EL1 of the left eye ocular optical system OL1.

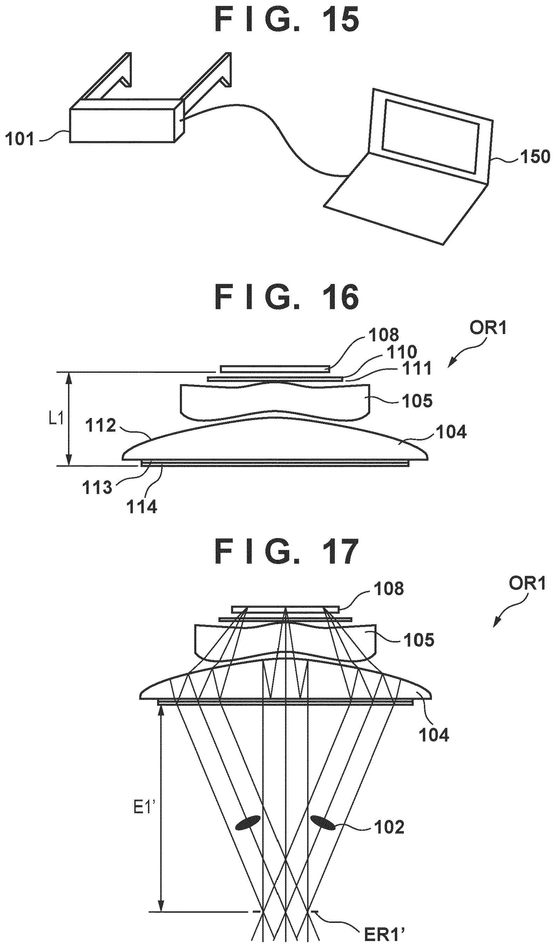

Reference sign 108 indicates a right eye display element, and reference sign 109 indicates a left eye display element. Each of the display elements 108 and 109 are flat, plate-type display elements, and in the present embodiment, organic EL elements are used. FIG. 15 is a diagram illustrating the external appearance of the HMD 101 and a personal computer 150 connected thereto. Each display element displays a display image (an original image) corresponding to an image signal output from the personal computer 150. The HMD 101 may be a device that has an image processing device installed therein and operates as a standalone device.

The ocular optical systems OR1 and OL1 project enlarged virtual images of the display image onto the right eye 102 and the left eye 103 of the observer by guiding light from the display elements 108 and 109 to the exit pupils ER1 and EL1, respectively. As a result, the observer can observe (a virtual image of) the display image displayed by the display elements 108 and 109 through the ocular optical systems OR1 and OL1.

In the present embodiment, the focal length of each ocular optical system is 12 mm, the horizontal display angle is 45°, the vertical display angle is 34°, and the diagonal display angle is 54°. An eye relief E1, which is a distance between the surface of each ocular optical system closest to the exit pupil side (the exit pupil-side surface of a polarization separation element 114, described later) and the exit pupil of the corresponding ocular optical system, is 18 mm.

The right eye and left eye ocular optical systems OR1 and OL1 in the present embodiment are optical systems which bend the optical path using polarized light, and the configurations thereof will be described using the right eye ocular optical system OR1. The same applies to the left eye ocular optical system OL1, and thus descriptions thereof will not be given.

As illustrated in FIG. 16, the right eye ocular optical system OR1 has a polarizing plate 110, a first phase plate 111, a display lens 105, a display lens 104, a second phase plate 113, and the polarization separation element (called a PBS hereinafter) 114, disposed in that order from the right eye display element 108 toward the exit pupil ER1. A half mirror 112 serving as a semi-transmissive reflective surface is formed on the surface of the display lens 104 on the display element side thereof. The second phase plate 113 and the PBS 114 are provided so as to be layered on the exit pupil side-surface of the display lens 104.

The polarizing plate 110, the first phase plate 111, the second phase plate 113, and the PBS 114 are all formed as flat plates. The polarization direction of first linearly-polarized light passing through the polarizing plate 110 is inclined by 45° with respect to the slow axis of the first phase plate 111, and the polarization direction of the first linearly-polarized light passing through the polarizing plate 110 is inclined by -45° with respect to the slow axis of the second phase plate 113 (i.e., by the same angle, but in the opposite direction from the slow axis of the first phase plate 111 with respect to the polarization direction of the first linearly-polarized light). The polarization direction of the first linearly-polarized light passing through the polarizing plate 110 and the polarization direction of second linearly-polarized light passing through the PBS 114 are orthogonal to each other.

Unpolarized light emitted from the right eye display element 108 passes through the polarizing plate 110 and becomes linearly-polarized light, which then passes through the first phase plate 111 to become circular polarized light, and then passes through the display lens 105. The circular polarized light then passes through the half mirror 112, the display lens 104, and the second phase plate 113, and becomes first linearly-polarized light as a result. This first linearly-polarized light has a polarization direction orthogonal to the polarization direction when passing through the PBS 114, and is therefore reflected by the PBS 114 and passes through the second phase plate 113 to become circular polarized light. This circular polarized light passes through the display lens 104 and is reflected by the half mirror 112, passes through the display lens 104 again, and then passes through the second phase plate 113 to become the second linearly-polarized light. The second linearly-polarized light has a polarization direction which matches the polarization direction when passing through the PBS 114, and thus passes through the PBS 114 and is guided to the exit pupil ER1 (the right eye 102). The light emitted from the left eye display element 109 is similarly guided to the exit pupil EL1 (the left eye 103) by the left eye ocular optical system OL1.

By configuring each ocular optical system to bend the optical path using polarized light in this manner, each ocular optical system can be made thinner in the optical axis direction, and the focal length of each ocular optical system can be shortened to enable the observation of images having a wide view angle.

It is desirable that the HMD is lightweight from the standpoint of being worn on the observer's head. As such, it is desirable that the display lenses constituting the ocular optical systems, an image capturing lens constituting an imaging optical system, and the like be made of a resin, which has a lower relative density than glass. Accordingly, in the present embodiment too, the display lenses 104 to 107 are resin lenses. The display lenses 104 and 106 furthest on the exit pupil side are plano-convex lenses having convex surfaces toward the display element side, and providing the half mirror 112 on the convex surfaces achieves a wide view angle while making the ocular optical systems thinner. Furthermore, the convex surfaces of the display lenses 104 and 106 are given an aspheric shape to increase an aberration correction effect. The display lenses 105 and 107 are double-sided aspheric lenses made of resin to increase the aberration correction effect.

However, the display lenses 105 and 107 have small outer diameters and little effect on the weight, and may therefore be glass lenses. The display lenses 104 and 106 may also be glass lenses as long as the weight of the HMD 101 as a whole is within a permissible range.

In the HMD 101 of the present embodiment, it is desirable that the eye relief E1 be at least 15 mm so as to be wearable even by an observer who is wearing glasses. However, if the eye relief is too long, the outer shape of the display lenses will become larger and increase the size of the HMD, and it is thus desirable that the eye relief be no greater than 25 mm. In other words, it is preferable that the eye relief E1 satisfies the following condition:

$$15\,\text{mm} \le E1 \le 25\,\text{mm} \qquad ...(7)$$

In the HMD 101 of the present embodiment, as illustrated in FIG. 17, the position of an exit pupil ER1' of the right eye ocular optical system OR1 when the eyeball (pupil) of the right eye 102 is facing (looking at) the left and right edges of the display surface of the right eye display element 108, i.e., an eye relief E1', is set to 28 mm, which is obtained by adding a 10 mm eyeball rotation radius to the eye relief E1 of 18 mm when the eyeball is facing the center of the display surface as illustrated in FIG. 14; the exit pupil diameter is set to 6 mm. The same applies to the exit pupil of the left eye ocular optical system OL1. Such settings enable light from the direction in which the eyeball is facing to enter the eyeball even when the eyeball rotates to observe the left and right edges of the display surface (as well as the top and bottom edges).

In an ocular optical system having a long eye relief, a short focal length, and which is thin, as with the ocular optical system of the present embodiment, the light emission angle from the display element (display surface) is large at peripheral view angles among the display view angles. If the light emission angle from the display surface is large, viewing angle characteristics such as the display luminance and display chromaticity are reduced, and the observed image becomes darker, an image having the correct color cannot be observed, or the like.

In the right eye ocular optical system OR1, the light rays emitted from the right eye display element (display surface) 108 and passing through the center of the exit pupil ER1 (ER1') of the ocular optical system OR1 are the main light rays. In this case, in the present embodiment, when the eyeball is facing the center of the display surface as illustrated in FIG. 14 (called a forward viewing state hereinafter), the emission angles from the display surface of the main light rays at a maximum peripheral view angle of 22.5° in the left and right directions (the horizontal direction) are 18° and -18° at the right and left edges of the display element, respectively. On the other hand, when the eyeball is facing the right edge and the left edge of the display surface in the horizontal direction as illustrated in FIG. 17 (called a right edge viewing state and a left edge viewing state, respectively, hereinafter), the emission angles from the display surface of the main light rays at the maximum peripheral view angle of 22.5° in the horizontal direction are 37° and -37°. In the present embodiment, the emission angle, from the display element (display surface) 108, of the main light rays at a maximum peripheral view angle of 17° in the vertical direction when in the forward viewing state is 14°, and when the eyeball is facing the upper edge or the lower edge in the vertical direction (called an upper edge viewing state and a lower edge viewing state, respectively, hereinafter), the absolute value of the emission angle, from the display surface, of the main light rays at a maximum peripheral view angle of 17° in the vertical direction is 29°. However, the main light rays in the forward viewing state, the upper edge viewing state, and the lower edge viewing state are designed to be tilted in the outward direction of the display element.

The emission angle from the display surface is the normal direction (0°) of the substrate 8 at the center of the display element, and increases roughly linearly with respect to the display view angle (the position of the display element). The radiation direction is a direction tilted in the outward direction of the display element. Accordingly, it is desirable that the microlenses of the display element be disposed such that the shift amount ΔML of the microlenses at the center of the display element is 0, with ΔML increasing with proximity to the edges, as illustrated in FIG. 7. In other words, the microlenses and the color filters are disposed such that the shift amount to the right and left sides with respect to the position of the light emission region (the pixel) increases with proximity to the right edge and the left edge of the display element in the horizontal direction thereof. Similarly, the microlenses and the color filters are disposed such that the shift amount to the upper and lower sides with respect to the position of the light emission region increases with proximity to the upper edge and the lower edge of the display element. In the present embodiment, the relationship between the maximum view angle of the display device and the radiation angle of the main light rays is kept roughly linear in the horizontal direction and the vertical direction, and thus if the shift amounts of the microlenses and the color filters are determined to optimize the viewing angle characteristics at the horizontal edges (the right edge viewing state and the left edge viewing state), which is the maximum view angle, the viewing angle characteristics at the upper and lower edges will also be roughly optimal values. The results of examinations in the present embodiment will be described hereinafter in terms of the characteristics in the right edge viewing state at the horizontal edge position of the display element.

The occurrence of ghost light, which is unwanted light, in the ocular optical systems OR1 and OL1 of the present embodiment will be described next with reference to FIG. 16. Again, the descriptions will refer to the right eye ocular optical system OR1, but the same applies to the left eye ocular optical system OL1.

In the ocular optical system OR1 which uses polarized light, as in the present embodiment, birefringence within the display lenses 104 and 105, the polarization characteristics of the polarizing plate 110, the phase plates 111 and 113, and the PBS 114, and the like result in the light emitted from the display element 108 being guided not long the normal optical path illustrated in FIGS. 14 and 17, but instead being guided directly to the right eye 102 of the observer without being reflected by the PBS 114, as illustrated in FIG. 18. This light becomes ghost light. This ghost light is produced when circular polarized light passing through the first phase plate 111 becomes elliptical polarized light due to birefringence within the display lenses 105 and 104, and the polarization direction of the linearly-polarized light after passing through the second phase plate 113 is tilted with respect to the original direction, after which the light is guided to the right eye 102 through the PBS 114. Even if there is no birefringence in the display lenses 104 and 105, ghost light will arise if the polarization characteristics of the polarizing plate 110, the phase plates 111 and 113, and the PBS 114 are not accurate.

In the ghost light illustrated in FIG. 18, the emission angle, from the display element (display surface) 108, of the main light rays for the maximum peripheral view angle of 22.5° in the horizontal direction when in the forward viewing state is 11°, which is tilted in the direction opposite from the normal line of the display surface with respect to the normal emission angle of the main light rays indicated in FIGS. 14 and 17. As such, by shifting the microlenses of the light-emitting element to match the normal emission angle of the main light rays as described above, not only can the viewing angle characteristics be improved, but the brightness of ghost light from the peripheral parts, including the edges of the display element, can be reduced.

Birefringence in a lens generally increases from the center of the lens to the peripheral parts thereof, and thus the intensity of ghost light caused by birefringence in the lens also increases from the center of the lens to the peripheral part thereof. Reducing the brightness of light from the peripheral parts of the display surface is therefore effective for reducing ghost light passing through the peripheral parts of the lens. In the present embodiment, when the main light ray angle of the normal light in the forward viewing state at the edge of the display element is represented by $\theta m$ and the radiation angle of the ghost light is represented by $\theta g$, it is desirable that the ocular optical system satisfies the following Formula (8).

$$|\theta m - \theta g| \geq 15° \qquad ...(8)$$

Effects achieved by combining the display element and the ocular optical system of the present embodiment will be described next. In the present embodiment, the organic EL element illustrated in FIG. 3B, which emits white light, was used in a configuration in which the color filter 20 is disposed between the microlens 15 and the light emission region 17. Table 1 shows the values of a microlens height h/D, radius r/D, and color filter top surface height L2/D, normalized by the inter-pixel pitch D.

Table 1

| | |
|---|---|
| MICROLENS HEIGHT h/D | 0.19 |
| MICROLENS RADIUS r/D | 0.46 |
| HEIGHT L2/D OF TOP SURFACE OF COLOR FILTER | 0.77 |

FIG. 19 illustrates the radiation angle dependence of a relative luminance $\Delta L$ in a first comparative example and a first working example. The first comparative example is a configuration in which the shift amount for the microlenses is 0. The first working example is a configuration in which the microlenses are shifted, and the values of a numerical aperture, $\varphi 1$ (angle $\varphi 1$), $\varphi 2$ (angle $\varphi 2$), and A are shown in Table 2. The radiation angle on the horizontal axis takes the direction in which the normal line from the display surface of the display element 108 extends as the direction of 0°, with the right side viewed from the right eye 102 being positive and the left side being negative. The vertical axis represents the relative luminance with the radiated light intensity at 0° in the first comparative example as 1. The results of the comparative example in FIG. 19 indicate that the luminous intensity decreases as the radiation angle increases, peaking at 0°, and decreases to 0.3 at the normal light radiation angle of 37° when in the right edge viewing state. On the other hand, the luminous intensity is high, at 0.9, at the radiation angle of -11° of the ghost light when in the forward viewing state. Accordingly, the luminous intensity in the direction of the ghosting is higher than the luminous intensity of the normal light. This is because, as illustrated in FIG. 4B, when the microlens shift amount $\Delta ML$ is 0, light is focused in the normal direction of the substrate 8, which reduces the light radiated to the wide-angle side and results in a higher luminous intensity for ghost light compared to the luminous intensity of the normal light. In general, light emitted from a finite emission area decreases in luminous intensity as the radiation angle increases. Accordingly, even with the configuration that does not have microlenses, indicated in FIG. 4A, the luminous intensity of the ghost light is likewise higher than the luminous intensity of the normal light.

On the other hand, the results of the first working example show that the luminous intensity increases as the radiation angle relative to the normal light radiation direction increases, increasing to 0.85 at the radiation angle of 37° of normal light in the right edge viewing state. On the other hand, at the radiation angle of -11° of the ghost light in the forward viewing state, the value is significantly lower, at 0.32. In this manner, the luminous intensity of the normal light can be make higher than the luminous intensity in the direction of the ghosting. The increase in the luminous intensity of the normal light emission is due to the refraction of the light 27 incident on the surface 28, as indicated in FIG. 4C. The drop in the luminous intensity of the ghost light is due to total reflection or refraction to the wide-angle side that occurs at the surface 29 of the microlens of the adjacent light-emitting element, as indicated in FIG. 4C. $\varphi 1$ in the first working example described here is 16.7, which satisfies Formula (5), which is the condition for the shift amount for the microlenses. Combining the polarizing optical system illustrated in FIG. 14 with a display element in which microlenses are shifted so as to satisfy Formula (5) in this manner makes it possible to increase the luminous intensity $\Delta L$ of normal light and simultaneously suppress ghost light.

Table 2

| | NUMERICAL APERTURE | φ1 | φ2 | A | LUMINOUS INTENSITY ΔL OF NORMAL LIGHT | LUMINOUS INTENSITY ΔL OF GHOST LIGHT |
|---|---|---|---|---|---|---|
| FIRST COMPARATIVE EXAMPLE | 30% | 0 | 0 | - | 0.30 | 0.90 |
| FIRST WORKING EXAMPLE | 30% | 16.7 | 14.0 | 0.84 | 0.85 | 0.32 |

The effect of the numerical aperture of the light-emitting element will be described next. Table 3 shows the luminous intensity ΔL of normal light and ghost light for the first working example, a second working example, and a third working example, which are examples having varying numerical apertures. The normal light at a numerical aperture of 40% was 0.82, but was 0.85 at a numerical aperture of 30% and 0.91 at a numerical aperture of 20%. In this manner, reducing the numerical aperture increases the luminous intensity of the normal light. This is due to an increase in the ratio of the region X to the light emission region 17, as indicated in FIG. 5A. In other words, this indicates that the light radiated in the light emission region is radiated in the normal light direction with high efficiency. On the other hand, with respect to the luminous intensity of ghost light, the value was 0.40 at a numerical aperture of 40%, but was 0.32 at a numerical aperture of 30% and 0.22 at a numerical aperture of 20%. Reducing the numerical aperture in this manner reduces the luminous intensity of the ghost light. The drop in the luminous intensity of the ghost light is due to a decrease in the overlap between the sum of the radiation regions Y1 and Y2 of the ghost light and the light emission region 17, indicated in FIG. 5B. In other words, in the polarizing optical system illustrated in FIG. 14, under the condition that Formula (5) is satisfied, reducing the numerical aperture will increase the normal light and reduce the ghost light.

Table 3

| | NUMERICAL APERTURE | φ1 | φ2 | A | LUMINOUS INTENSITY ΔL OF NORMAL LIGHT | LUMINOUS INTENSITY ΔL OF GHOST LIGHT |
|---|---|---|---|---|---|---|
| SECOND WORKING EXAMPLE | 40% | 16.7 | 14.0 | 0.84 | 0.82 | 0.40 |
| FIRST WORKING EXAMPLE | 30% | 16.7 | 14.0 | 0.84 | 0.85 | 0.32 |
| THIRD WORKING EXAMPLE | 20% | 16.7 | 14.0 | 0.84 | 0.91 | 0.22 |

The effect of the shift amount ΔCF for the color filters will be described next based on Table 4. Table 4 shows the color shift ΔE of the normal light and the luminous intensity ΔL of the ghost light when φ1 is fixed and φ2 is varied (when A is varied). Table 4 also shows the first comparative example as reference values.

The definition of the color shift ΔE is indicated by Formal (9), below and is the change in hue in an a*b* space. The references a0 and b0 here are the values at 0° in the first comparative example.

$$\Delta E = \sqrt{((a - a0)^2 + (b - b0)^2)} \qquad ...(9)$$

The color shift ΔE of normal light at A = 0.84 was 20, but was 18 at A = 0.43 and 17 at A = 0 (no color filter shift). In other words, reducing the shift amount for the color filters reduces the color shift ΔE of the normal light. This drop in the color shift is due to light 33 radiated to the wide-angle side being blocked by the adjacent color filter, as illustrated in FIG. 6B. On the other hand, the ghost light was found to be independent of the shift amount for the color filters, being 0.32 at A = 0.84, 0.32 at A = 0.43, and 0.31 at A = 0. In other words, this indicates that the color shift ΔE of the normal light can be suppressed without increasing the luminous intensity of the ghost light. If A = 0.85 or less, the color shift ΔE of normal light can be reduced more than when the shift amount for the microlenses is 0. In other words, in addition to satisfying the condition of Formula (5), satisfying Formula (6) makes it possible, in the polarizing optical system illustrated in FIG. 14, to ensure the luminous intensity of normal light and to suppress ghost light, as well as to reduce the color shift ΔE.

Table 4

| | NUMERICAL APERTURE | φ1 | φ2 | A | COLOR SHIFT ΔE OF NORMAL LIGHT | LUMINOUS INTENSITY ΔL OF GHOST LIGHT |
|---|---|---|---|---|---|---|
| FIRST COMPARATIVE EXAMPLE | 30% | 0.0 | 0.0 | - | 21 | 0.90 |
| FIRST WORKING EXAMPLE | 30% | 16.7 | 14.0 | 0.84 | 20 | 0.32 |
| FOURTH WORKING EXAMPLE | 30% | 16.7 | 7.1 | 0.43 | 18 | 0.32 |
| FIFTH WORKING EXAMPLE | 30% | 16.7 | 0.0 | 0.00 | 17 | 0.31 |

The effects in the polarizing optical system illustrated in FIG. 14 have been described thus far. The results of these studies are the results of the study for the angle of the main light rays in the right edge viewing state at the right edge of the display element. However, if the maximum display view angle is no greater than 60°, the observer can recognize the peripheral parts of the image in the forward viewing state, and thus the shift amount for the microlenses and the color filters may be determined assuming the forward viewing state to the extent that Formulas (5) and (6) are satisfied.

In this manner, in the present embodiment, shifting the microlens with respect to the pixel makes it possible to reduce ghost light while improving viewing angle characteristics such as luminance and color shift at the peripheral parts of the observed image.

Birefringence in the lens is more likely to occur when the lens is manufactured by molding a resin material, with the difference in cooling between the thin parts and the thick parts of the lens during cooling after the molding increasing as the uneven thickness ratio of the lens increases, which in turn leads to an increase in birefringence.

The uneven thickness ratio of the display lens 104 having a reflective surface (half mirror 112) having the highest optical power increases in the ocular optical system OR1 having a wide view angle and a thin profile, as in the present embodiment. The uneven thickness ratio in the optically effective region of the display lens 104 is 2.0, and it is desirable that the uneven thickness ratio be at least 1.5 and at most 4. If the uneven thickness ratio is less than 1.5, the optical power of the display lens 104 will decrease, and the curvature radius or the thickness of the display lens 104 will increase. If the optical power of the display lens 104 decreases, it becomes impossible to achieve a wide view angle, or it becomes necessary to add a lens having a high optical power, which in turn makes it impossible to make the ocular optical system OR1 thinner. If the thickness of the display lens 104 increases, the ocular optical system OR1 cannot be made thinner. On the other hand, if the uneven thickness ratio is greater than 4, the birefringence of the display lens 104 will become too great, which increases the intensity of the ghost light. Note that the optical path of the normal light and the optical path of the ghost light in the ocular optical system differ in terms of the number of reflections within the ocular optical system.

If a thickness L1 of the ocular optical system OR1 is defined as the distance from the surface of the PBS 114 on the exit pupil side to the display element 108, the thickness L1 is 13 mm, and the ratio L1/E1 between the thickness L1 and eye relief E1, which is 18 mm, is 0.72. It is desirable that this value satisfies the condition

$$0.60 \leq L1/E1 \leq 1.00 \qquad ...(10)$$

in order to achieve both an appropriate length for the eye relief and a thinner ocular optical system. If L1/E1 is lower than 0.60, the eye relief becomes too long, the outer diameter of the display lens becomes larger, and the HMD 101 also becomes larger, which is undesirable. Moreover, the birefringence of the display lens 104 increases with the outer diameter, which increases the intensity of ghost light. On the other hand, if L1/E1 is greater than 1.00, the ocular optical system becomes thicker, making the HMD 101 larger; furthermore, the eye relief becomes too short, giving the observer a sense of oppression or making it impossible for an observer wearing glasses to wear the HMD, which is undesirable.

In the present embodiment, a maximum diagonal half-view angle $\theta 1$ of the ocular optical system OR1 is 27°. In this case, $E1 \times \tan\theta 1 = 9.2$ mm. It is desirable that this value satisfies the condition

$$8mm \leq E1 \times \tan\theta 1 \leq 20mm \qquad \ldots (11)$$

in order to achieve both an appropriate length for the eye relief and a wider view angle in the ocular optical system. If $E1 \times \tan\theta 1$ is lower than 8 mm, the eye relief becomes too short, giving the observer a sense of oppression or making it impossible for an observer wearing glasses to wear the HMD, which is undesirable. The display view angle of the ocular optical system also becomes too narrow, and thus natural images having a sense of presence cannot be observed. On the other hand, if $E1 \times \tan\theta 1$ is higher than 20 mm, the eye relief becomes too long, the outer diameter of the display lens 104 becomes larger, and the HMD 101 also becomes larger, which is undesirable. Moreover, the birefringence of the display lens 104 increases with the outer diameter, which increases the intensity of ghost light. Furthermore, the display view angle becomes too wide, causing the emission angle of the main light rays from the display surface to increase at peripheral view angles, which worsens the viewing angle characteristics.

A polarizing plate may be disposed between the PBS 114 and the exit pupil of each ocular optical system to reduce ghost light caused by ambient light and increase the contrast of the image being observed.

Furthermore, in the present embodiment, as illustrated in FIG. 16, the surface of the display lens 104 on the exit pupil side, which is formed such that the second phase plate 113 and PBS 114 are layered, is flat. This is done to achieve both a longer eye relief and a thinner ocular optical system. If this surface has a shape which is concave in the direction of the exit pupil, the display lens 104 becomes thicker to ensure the eye relief at the peripheral parts thereof. If this surface has a shape which is convex in the direction of the exit pupil, the lens becomes thicker to ensure the thickness of the peripheral parts of the display lens 104.

The first and second phase plates 111 and 113 in the present embodiment are waveplates having a phase difference of $\lambda/4$, but the phase difference may be shifted from $\lambda/4$ to cancel out the birefringence of the lens 104 and lens 105. In this case, it is desirable that the sum of the phase difference between the lens 104 and the phase plate 113 be at least $3\lambda/20$ and at most $7\lambda/20$. Additionally, it is desirable that the sum of the phase difference between the lens 105 and the first phase plate 111 be at least $3\lambda/20$ and at most $7\lambda/20$. Outside this range, the intensity of ghost light increases, making natural observation impossible. The conditions indicated by Formulas (5) to (7), (10) and (11) described in the present embodiment are the same in the second embodiment described below.

At least one additional one of a second half mirror, a third phase plate, a second PBS, and a fourth phase plate may be disposed between the first phase plate 111 and the half mirror 112. When disposing a second half mirror, an additional convex surface may be formed in the direction of the display element side, and the second half mirror may be provided on that convex surface.

The third phase plate or the fourth phase plate may be used as a variable phase plate by applying an electrical signal. For example, the phase difference of the phase plate may be switched so that when on, the half mirror 112 is in a polarization state where normal light is reflected by the half mirror 112, and when off, the phase plate is in a polarization state where normal light is reflected by the second half mirror. The phase plate may also be used as a foveated display that time-division multiplexes high-resolution video for the center of the field of view and low-resolution video for the peripheral field of view by switching in this manner.

A variable focus lens may be disposed inside or outside the half mirror 112 and the PBS 114. Variable focus lenses can be glass lenses, polymer lenses, liquid crystal lenses, or a combination thereof. The liquid crystal lens may be a Fresnel liquid crystal lens having a segmented parabolic phase shape, a Pancharatnum-Berry phase lens, or a combination thereof. Multiple Pancharatnum-Berry phase lenses may be layered. An additional phase plate that can be switched on and off by applying an electrical signal may be disposed on the Pancharatnum-Berry Phase lens, and multiple alternating layers of Pancharatnum-Berry phase lenses and phase plates may be used.

The preferred lens materials, shapes, and the like described in the present embodiment also apply to the second embodiment.

Second Embodiment

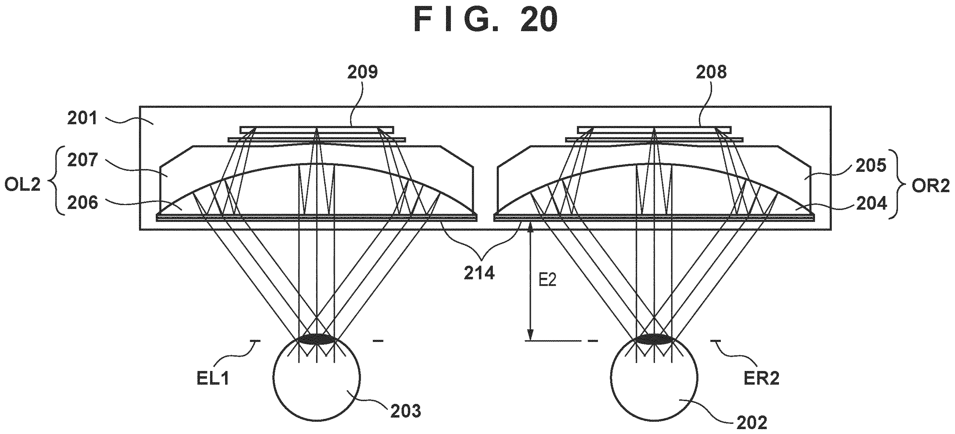

FIG. 20 illustrates shows the configuration of an HMD 201 according to a second embodiment of the present invention. Reference sign 202 indicates the right eye of the observer, and reference sign 203 indicates the left eye of the observer. Display lenses 204 and 205 constitute a right eye ocular optical system OR2, and display lenses 206 and 207 constitute a left eye ocular optical system OL2. Each ocular optical system is a coaxial optical system constituted by two display lenses. The right eye 202 of the observer is located at an exit pupil ER2 of the right eye ocular optical system OR2, and the left eye 203 of the observer is located at an exit pupil EL2 of the left eye ocular optical system OL2.

Reference sign 208 indicates a right eye display element, and reference sign 209 indicates a left eye display element. Each of the display elements is flat, plate-type display elements, and in the present embodiment, organic EL elements are used.

The ocular optical systems OR2 and OL2 project enlarged virtual images of a display image displayed by the display elements 208 and 209 (an original image) onto the right eye 202 and the left eye 203 of the observer by guiding light from the display elements 208 and 209 to the exit pupils ER2 and EL2, respectively. As a result, the observer can observe (a virtual image of) the display image displayed by the display elements 208 and 209 through the ocular optical systems OR2 and OL2.

In the present embodiment, the focal length of each ocular optical system is 13 mm, the horizontal display angle is 60°, the vertical display angle is 60°, and the diagonal display angle is 78°. An eye relief E2, which is a distance between the surface of each ocular optical system closest to the exit pupil side (the exit pupil-side surface of a polarization separation element 214, described later) and the exit pupil of the corresponding ocular optical system, is 20 mm.

As in the first embodiment, the right eye and left eye ocular optical systems OR2 and OL2 in the present embodiment are optical systems which bend the optical path using polarized light, and the configurations thereof will be described using the right eye ocular optical system OR2. As illustrated in FIG. 21, the right eye ocular optical system OR2 has a polarizing plate 210, a first phase plate 211, a display lens 205, a display lens 204, a second phase plate 213, and the PBS 214, disposed in that order from the right eye display element 208 toward the exit pupil ER2. A half mirror 212 serving as a semi-transmissive reflective surface is formed through deposition on the surface of the display lens 204 on the display element side thereof. The second phase plate 213 and the PBS 214 are provided so as to be layered on the exit pupil side-surface of the display lens 204.

The polarizing plate 210, the first phase plate 211, the second phase plate 213, and the PBS 214 are all formed as flat plates. The polarization direction of first linearly-polarized light passing through the polarizing plate 210 is inclined by 45° with respect to the slow axis of the first phase plate 211, and the polarization direction of the first linearly-polarized light passing through the polarizing plate 210 is inclined by -45° with respect to the slow axis of the second phase plate 213. The polarization direction of the first linearly-polarized light passing through the polarizing plate 210 and the polarization direction of second linearly-polarized light passing through the PBS 214 are orthogonal to each other.

Unpolarized light emitted from the right eye display element 208 passes through the polarizing plate 210 and becomes linearly-polarized light, which then passes through the first phase plate 211 to become circular polarized light, and then passes through the display lens 205. The circular polarized light then passes through the half mirror 212, the display lens 204, and the second phase plate 213, and becomes first linearly-polarized light as a result. This first linearly-polarized light has a polarization direction orthogonal to the polarization direction when passing through the PBS 214, and is therefore reflected by the PBS 214 and passes through the second phase plate 213 to become circular polarized light. This circular polarized light passes through the display lens 204 and is reflected by the half mirror 212, passes through the display lens 204 again, and then passes through the second phase plate 213 to become the second linearly-polarized light. The second linearly-polarized light has a polarization direction which matches the polarization direction when passing through the PBS 214, and thus passes through the PBS 214 and is guided to the exit pupil ER2 (the right eye 202). The light emitted from the left eye display element 209 is similarly guided to the exit pupil EL2 (the left eye 203) by the left eye ocular optical system OL2.

In the present embodiment, as in the first embodiment, by configuring each ocular optical system to bend the optical path using polarized light, each ocular optical system can be made thinner, and the focal length of each ocular optical system can be shortened to enable the observation of images having a wide view angle.

In the present embodiment, two display lenses are joined in each ocular optical system to reduce the thickness thereof in the optical axis direction to 13.5 mm. Furthermore, as mentioned above, 20 mm is ensured as the eye relief E2 of the ocular optical system. Joining the two display lenses into a joined lens makes it easier for the body of the HMD 201 to hold the display lenses.

In the present embodiment too, the display lenses 204 to 207 are resin lenses, and furthermore, the display lenses 204 to 207 are aspherical lenses to enhance the aberration correction effect.

Additionally, because the display lenses 204 and 205 are joined lenses, the half mirror 212 may be provided on the surface of the display lens 205 on the exit pupil side thereof. Even in this case, the surface on which the half mirror is provided is convex in the direction of the display element 208.

In the HMD 201 of the present embodiment, as illustrated in FIG. 22, the position of an exit pupil ER2' of the right eye ocular optical system OR2 when the eyeball (pupil) of the right eye 202 is facing (looking at) the left and right edges of the display surface of the right eye display element 208, i.e., an eye relief E2', is set to 30 mm, which is obtained by adding a 10 mm eyeball rotation radius to the eye relief E2 of 20 mm when the eyeball is facing the center of the display surface as illustrated in FIG. 20; the exit pupil diameter is set to 6 mm. The same applies to the exit pupil of the left eye ocular optical system OL2. Such settings enable light from the direction in which the eyeball is facing to enter the eyeball even when the eyeball rotates to observe the left and right edges of the display surface (as well as the top and bottom edges).

In the right eye ocular optical system OR2, the light rays emitted from the right eye display element (display surface) 208 and passing through the center of the exit pupil ER2 (ER2') of the ocular optical system OR2 are the main light rays. In this case, in the present embodiment, as illustrated in FIG. 20, the emission angles from the display surface of the main light rays at a maximum peripheral view angle of 30° in the left and right directions (the horizontal direction) when in the forward viewing state are 23° and -23° at the right and left edges of the display element, respectively. On the other hand, as illustrated in FIG. 22, the emission angles from the display surface of the main light rays at the maximum peripheral view angle of 30° in the horizontal direction when in the right edge viewing state and the left edge viewing state are 47° and -47°. In the present embodiment, the emission angle, from the display element (display surface) 208, of the main light rays at the maximum peripheral view angle of 30° in the vertical direction when in the forward viewing state is 23°, and the absolute value of the emission angle, from the display surface, of the main light rays at the maximum peripheral view angle of 30° in the vertical direction when in the upper edge viewing state and the lower edge viewing state is 47°. However, the main light rays in the forward viewing state, the upper edge viewing state, and the lower edge viewing state are designed to be tilted in the outward direction of the display element. In other words, the present embodiment satisfies Formula (8).

The emission angle from the display surface is the normal direction (0°) of the substrate at the center of the display element, and increases roughly linearly with respect to the display view angle. The radiation direction is a direction tilted in the outward direction of the display element 208. Accordingly, it is desirable that the microlenses of the display element of the present embodiment be disposed such that the shift amount $\Delta ML$ of the microlenses at the center of the display element is 0, with $\Delta ML$ increasing with proximity to the edges, as illustrated in FIG. 7. In other words, the microlenses and the color filters are disposed such that the shift amount to the right and left sides with respect to the position of the light emission region (the pixel) increases with proximity to the right edge and the left edge of the display element in the horizontal direction thereof. Similarly, the microlenses and the color filters are disposed such that the shift amount to the upper and lower sides with respect to the position of the light emission region increases with proximity to the upper edge and the lower edge of the display element. In the present embodiment, the relationship between the maximum view angle of the display device and the radiation angle of the main light rays is kept roughly linear in the horizontal direction and the vertical direction, and thus if the shift amounts of the microlenses and the color filters are determined to optimize the viewing angle characteristics at the horizontal edges (the right edge viewing state and the left edge viewing state), which is the maximum view angle, the viewing angle characteristics at the upper and lower edges will also be roughly optimal values. The results of examinations in the present embodiment will be described hereinafter in terms of the characteristics in the right edge viewing state at the horizontal edge position of the display element.

In the ocular optical systems OR2 and OL2 of the present embodiment, ghost light is produced for the same reason as in the first embodiment. As illustrated in FIG. 23, the emission angle, from the display element (display surface) 208, of the main light rays for the maximum peripheral view angle of 30° in the horizontal direction when in the forward viewing state is 15°, which is tilted in the direction opposite from the normal line of the display surface with respect to the normal emission angle of the main light rays indicated in FIGS. 20 and 22. As such, by shifting the microlenses of the light-emitting element to match the normal emission angle of the main light rays as described above, not only are the viewing angle characteristics improved, but the brightness of ghost light from the peripheral parts, including the edges of the display surface, can be reduced.

Effects achieved by combining the display element and the ocular optical system of the present embodiment will be described next. The characteristics in the right edge viewing state at the horizontal edge position of the display element will be described, as mentioned above. Here, as in the first embodiment, the organic EL element illustrated in FIG. 3B, which emits white light, was used in a configuration in which the color filter 20 is disposed between the microlens 15 and the light emission region 17. The microlens height h/D, the radius r/D, and height L2/D of the color filter top surface, normalized by the inter-pixel pitch D, are the same as in the first embodiment.

Table 5 shows the radiation angle dependence of a relative luminance $\Delta L$ in a first comparative example and a sixth working example. The first comparative example is a configuration in which the shift amount for the microlenses is 0. The sixth working example is a configuration in which the microlenses are shifted, and the values of the numerical aperture, $\varphi 1$, $\varphi 2$, and A are shown in Table 5. Referring to FIG. 19, which shows the results of the values in Table 5 and the first working example, in the first comparative example, the luminous intensity decreases as the radiation angle increases, peaking at 0°, and decreases to 0.09 at the normal light radiation angle of 47° when in the right edge viewing state. On the other hand, the luminous intensity is high, at 0.82, at the radiation angle of -15° of the ghost light in the forward viewing state. Accordingly, the luminous intensity in the direction of the ghosting is higher than the luminous intensity of the normal light.

This is because, as illustrated in FIG. 4B, when the microlens shift amount $\Delta ML$ is 0, light is focused in the normal direction of the substrate 8, which reduces the light radiated to the wide-angle side and results in a higher luminous intensity for ghost light compared to the luminous intensity of the normal light. In general, light emitted from a finite emission area decreases in luminous intensity as the radiation angle increases. Accordingly, even with the configuration that does not have microlenses, indicated in FIG. 4A, the luminous intensity of the ghost light is likewise higher than the luminous intensity of the normal light.

On the other hand, the results of the sixth working example show that the luminous intensity increases with progress toward the radiation direction of normal light, increasing to 0.65 at the radiation angle of 47° of normal light in the right edge viewing state. On the other hand, at the radiation angle of -15° of the ghost light in the forward viewing state, the value is significantly lower, at 0.23. In this manner, the luminous intensity of the normal light can be made higher than the luminous intensity in the direction of the ghosting. The increase in the luminous intensity of the normal light emission is due to the refraction of the light 27 incident on the surface 28, as indicated in FIG. 4C. The drop in the luminous intensity of the ghost light is due to total reflection or refraction to the wide-angle side that occurs at the surface 29 of the microlens of the adjacent light-emitting element, as indicated in FIG. 4C. φ1 in the sixth working example described here is 16.7, which satisfies Formula (5), which is the condition for the shift amount for the microlenses. Combining the polarizing optical system illustrated in FIG. 20 with a display element in which microlenses are shifted so as to satisfy Formula (5) in this manner makes it possible to increase the luminous intensity ΔL of normal light and simultaneously suppress ghost light.

Table 5

| | NUMERICAL APERTURE | φ1 | φ2 | A | LUMINOUS INTENSITY ΔL OF NORMAL LIGHT | LUMINOUS INTENSITY ΔL OF GHOST LIGHT |
|---|---|---|---|---|---|---|
| FIRST COMPARATIVE EXAMPLE | 30% | 0 | 0 | - | 0.09 | 0.82 |
| SIXTH WORKING EXAMPLE | 30% | 21.8 | 14.0 | 0.64 | 0.65 | 0.23 |

The effect of the numerical aperture of the light-emitting element will be described next. Table 6 shows the luminous intensity ΔL of normal light and ghost light for sixth to eighth working examples, which are examples having varying numerical apertures. The normal light at a numerical aperture of 40% was 0.71, but was 0.75 at a numerical aperture of 30% and 0.94 at a numerical aperture of 20%. In this manner, reducing the numerical aperture increases the luminous intensity of the normal light. This is due to an increase in the ratio of the region X to the light emission region 17, as indicated in FIG. 5A. In other words, this indicates that the light radiated in the light emission region 17 is radiated in the normal light direction with high efficiency. On the other hand, with respect to the luminous intensity of ghost light, the value was 0.30 at a numerical aperture of 40%, but was 0.27 at a numerical aperture of 30% and 0.17 at a numerical aperture of 20%. It can therefore be seen that reducing the numerical aperture in this manner reduces the luminous intensity of the ghost light. The drop in the luminous intensity of the ghost light is due to a decrease in the overlap between the sum of the radiation regions Y1 and Y2 of the ghost light and the light emission region 17, indicated in FIG. 5B. In other words, in the polarizing optical system illustrated in FIGS. 20 to 22, under the condition that Formula (5) is satisfied, reducing the numerical aperture will increase the normal light and reduce the ghost light. In order to increase the normal light and reduce ghost light, it is desirable that the numerical aperture be no greater than 52%.

Table 6

| | NUMERICAL APERTURE | φ1 | φ2 | A | LUMINOUS INTENSITY ΔL OF NORMAL LIGHT | LUMINOUS INTENSITY ΔL OF GHOST LIGHT |
|---|---|---|---|---|---|---|
| SEVENTH WORKING EXAMPLE | 40% | 21.8 | 14.0 | 0.64 | 0.71 | 0.30 |
| SIXTH WORKING EXAMPLE | 30% | 21.8 | 14.0 | 0.64 | 0.75 | 0.27 |
| EIGHTH WORKING EXAMPLE | 20% | 21.8 | 14.0 | 0.64 | 0.94 | 0.17 |

Table 7 shows the effect of the color filter shift amount ΔCF. Table 7 shows the color shift ΔE of the normal light and the luminous intensity ΔL of the ghost light when φ1 is fixed and φ2 is varied (when A is varied). Table 7 also shows the first comparative example as reference values.

The color shift ΔE of normal light at A = 0.64 was 31, but was 28 at A = 0.33 and 25 at A = 0 (no color filter shift). In other words, reducing the shift amount for the color filters reduces the color shift ΔE of the normal light. In addition, the sixth, ninth, and tenth working examples satisfy Formula (6) and therefore have a lower color shift ΔE than in the first comparative example. This drop in the color shift is due to light 33 radiated to the wide-angle side being blocked by the adjacent color filter, as illustrated in FIG. 6B. On the other hand, the ghost light was found to be independent of the shift amount for the color filters, being 0.23 at A = 0.64, 0.28 at A = 0.28, and 0.24 at A = 0. In other words, this indicates that the color shift ΔE of the normal light can be suppressed without increasing the luminous intensity of the ghost light. If A = 0.85 or less, the color shift ΔE of normal light can be reduced more than when the shift amount for the microlenses is 0. In other words, in addition to satisfying the condition of Formula (5), satisfying Formula (6) makes it possible, in the polarizing optical system illustrated in FIG. 20, to increase the luminous intensity of normal light and to suppress ghost light, as well as to reduce the color shift ΔE.

Table 7

| | NUMERICAL APERTURE | φ1 | φ2 | A | COLOR SHIFT ΔE OF NORMAL LIGHT | LUMINOUS INTENSITY ΔL OF GHOST LIGHT |
|---|---|---|---|---|---|---|
| FIRST COMPARATIVE EXAMPLE | 30% | 0.0 | 0.0 | - | 37 | 0.82 |
| SIXTH WORKING EXAMPLE | 30% | 21.8 | 14.0 | 0.64 | 31 | 0.23 |
| NINTH WORKING EXAMPLE | 30% | 21.8 | 7.1 | 0.33 | 28 | 0.28 |
| TENTH WORKING EXAMPLE | 30% | 21.8 | 0.0 | 0.00 | 25 | 0.24 |

When the maximum display view angle is greater than 60°, the wide view angle makes it difficult for the observer to recognize the peripheral parts of the image when in the forward viewing state. Accordingly, it is preferable to determine the shift amount of the color filter by assuming the emission angle of the main light rays from the display surface in the direction the viewer is looking when looking at the peripheral parts of the image, rather than when in the forward viewing state. However, depending on the lens design, light may be vignetted at the edges of the display element, and it is therefore not absolutely necessary to align with the edges.

In the present embodiment too, the uneven thickness ratio of the display lens 204 having a reflective surface (half mirror 212) having the highest optical power increases in the right eye ocular optical system OR2 having a wide view angle and a thin profile. The display lenses 204 and 205 are joined, and thus the curvature radius of the joined surface of the display lens 205 with the display lens 204 is short, and the uneven thickness ratio of the display lens 205 is also large. In the present embodiment, the uneven thickness ratio in the optically effective region of the display lens 204 is 3.6, and the uneven thickness ratio in the optically effective region of the display lens 205 is 2.8. As described in the first embodiment, it is desirable that the uneven thickness ratio be at least 1.5 and at most 4.

If a thickness L2 of the right eye ocular optical system OR2 is defined as the distance from the surface of the PBS 214 on the observer's right eye 202 side to the right eye display element 208, the thickness L2 is 13.5 mm, and the ratio L2/E2 between the thickness L2 and the eye relief E2 is 0.68. It is desirable that this value be at least 0.6 and at most 1 to achieve both an appropriate eye relief length and a thinner ocular optical system.

In the present embodiment, the eye relief E2 of the right eye ocular optical system OR2 is 20 mm, and a maximum diagonal half-view angle θ2 is 39°. In this case, E2×tanθ2 = 16.2 mm, which satisfies the condition of Formula (11). The uneven thickness ratio, L2/E2, and E2×tanθ2 are the same for the left eye ocular optical system OL2.

In the present embodiment too, a polarizing plate may be disposed between the PBS 214 and the exit pupil of each ocular optical system to reduce ghost light caused by ambient light and increase the contrast of the image being observed.

Third Embodiment

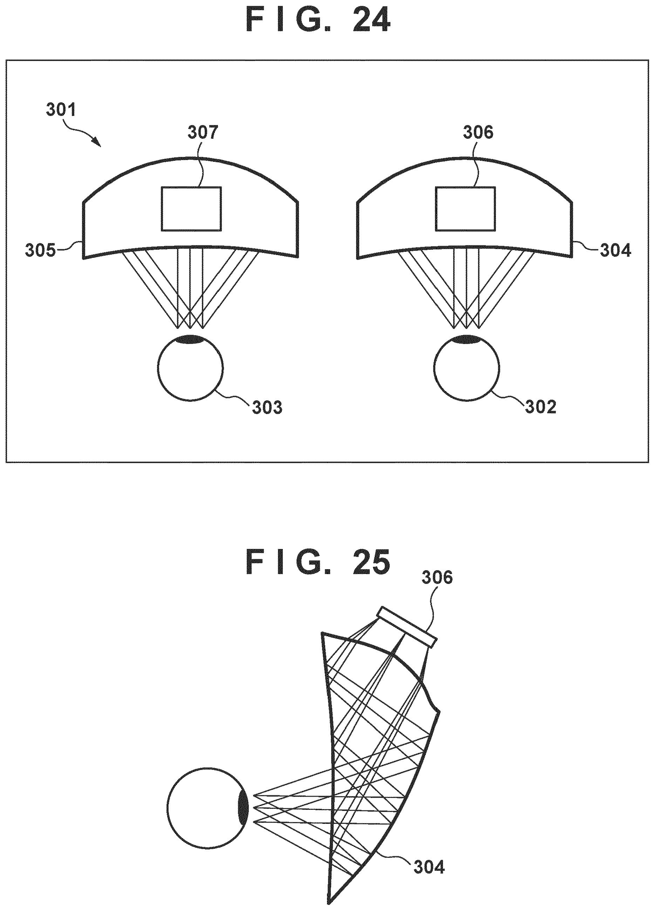

The configuration of an HMD 301 according to a third embodiment will be described next. FIG. 24 is a diagram illustrating the ocular optical system of the HMD 301. In the drawing, reference sign 302 indicates the observer's right eye, reference sign 303 indicates the observer's left eye, reference sign 304 indicates a right eye ocular optical system, reference sign 305 indicates a left eye ocular optical system, reference sign 306 indicates a right eye image display element, and reference sign 307 indicates a left eye image display element.

The right eye ocular optical system 304 magnifies and projects an original image displayed by the right eye image display element 306 and guides the image to the observer's right eye 302, while the left eye ocular optical system 305 magnifies and projects an original image displayed by the left eye image display element 307 and guides the image to the observer's left eye 303. The horizontal display angle for the right eye ocular optical system 304 and the left eye ocular optical system 305 is 40°, the vertical display angle is 30°, and the diagonal display angle is 50°.

As illustrated in FIG. 25, the ocular optical system of the present embodiment uses an eccentric reflective surface to bend the optical path, which reduces the thickness of the optical system. The right eye ocular optical system 304 is constituted by a transparent body filled with an optical medium such as glass or plastic having a refractive index greater than 1. The same applies to the left eye ocular optical system.

The light rays from the right eye image display element 306 are reflected twice in the right eye ocular optical system 304, and are guided to the right eye 302. The emission surface to the eye in the right eye ocular optical system 304 is an optical surface having reflection and transmission effects, and it is therefore desirable that the reflection be total internal reflection to eliminate light intensity loss. In addition, by making the surface constituting the right eye ocular optical system 304 a freeform surface shape, the degree of freedom for eccentric aberration correction is increased, which enables image display with good image quality. The same applies to the left eye ocular optical system 305.

Similar to the first embodiment and the second embodiment, the ocular optical system of the present embodiment has a large emission angle from the image display element at peripheral view angles, and there is thus a risk that the viewing angle characteristics will deteriorate at the peripheral parts, resulting in reduced luminance and making it impossible to observe images with correct colors.

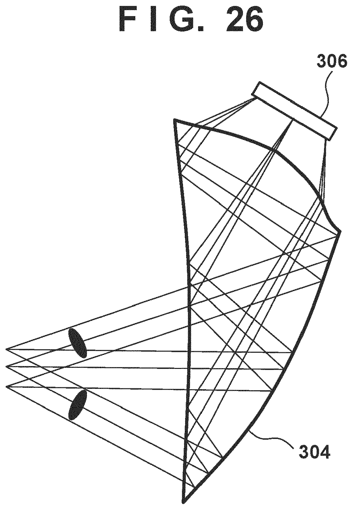

In the ocular optical system of the present embodiment, the emission angle of the main light rays from the image display element is 20° at a maximum peripheral view angle of 20° in the horizontal direction when the observer is looking forward, as illustrated in FIG. 24. Additionally, the emission angle of the main light rays from the image display element is 30° at a maximum peripheral view angle of 20° in the horizontal direction when the observer is looking at the edges in the horizontal direction, as illustrated in FIG. 24. Here, the main light rays are the light rays that pass through the center of the exit pupil of the ocular optical system. Although the left and right edges in the horizontal direction have been described thus far, the same applies to the top and bottom edges in the vertical direction. In the ocular optical system of the present embodiment, the emission angle of the main light rays from the image display element is 15° at a maximum peripheral view angle of 15° in the vertical direction when the observer is looking forward, as illustrated in FIG. 25. Additionally, the emission angle of the main light rays from the image display element is 22.5° at a maximum peripheral view angle of 15° in the vertical direction when the observer is looking at the edges in the vertical direction, as illustrated in FIG. 26. However, the main light rays in the forward viewing state, the right edge viewing state, the left edge viewing state, the upper edge viewing state, and the lower edge viewing state are designed to be tilted in the outward direction of the display element. The emission angle from the display surface is the normal direction (0°) of the substrate 8 at the center of the display element, and increases roughly linearly with respect to the display view angle.

The radiation direction is a direction tilted in the outward direction of the display element. Accordingly, it is desirable that the microlenses of the display element of the present embodiment be disposed such that the shift amount ΔML of the microlenses at the center of the display element is 0, with ΔML increasing with proximity to the edges, as illustrated in FIG. 7. In other words, the microlenses and the color filters are disposed such that the shift amount to the right and left sides with respect to the position of the light emission region (the pixel) increases with proximity to the right edge and the left edge of the display element in the horizontal direction thereof. Similarly, the microlenses and the color filters are disposed such that the shift amount to the upper and lower sides with respect to the position of the light emission region increases with proximity to the upper edge and the lower edge of the display element. In the present embodiment, the relationship between the maximum view angle of the display device and the radiation angle of the main light rays is kept roughly linear in the horizontal direction and the vertical direction, and thus if the shift amounts of the microlenses and the color filters are determined to optimize the viewing angle characteristics in the direction in which ghosting occurs, i.e., in the upper edge viewing state and the lower edge viewing state, the viewing angle characteristics at the horizontal edges will also be roughly optimal values. The results of examinations in the present embodiment will be described hereinafter in terms of the characteristics in the lower edge viewing state in the vertical direction of the display element.

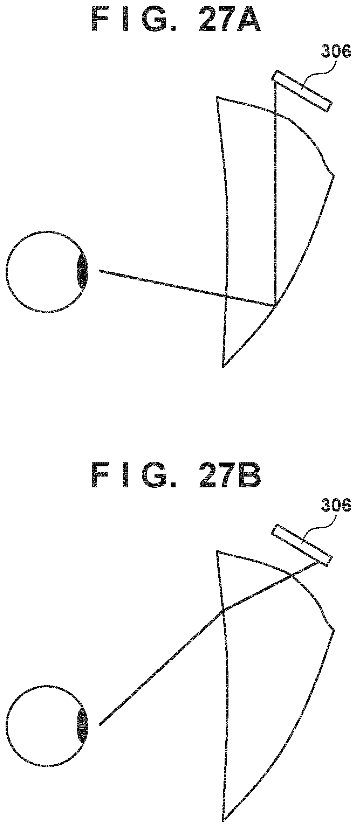

In the case the ocular optical system of the present embodiment, ghost light is produced in optical paths such as those illustrated in FIGS. 27A and 27B. The optical path of the ghost light from the top edge of the image display element is illustrated in FIG. 27A, and the optical path of the ghost light from the bottom edge of the image display element is illustrated in FIG. 27B. In the optical path of the ghost light illustrated in FIG. 27A, an emission angle θ3 of the main light rays from the top edge of the image display element 306 is -28° when the observer is looking forward.

Additionally, in the optical path of the ghost light illustrated in FIG. 27B, the emission angle θ3 of the main light rays from the bottom edge of the image display element is -34° when the observer is looking forward. In other words, the present embodiment satisfies Formula (8).

Effects achieved by combining the display element and the ocular optical system of the present embodiment will be described next. The characteristics in the lower edge viewing state at the vertical position of the display element will be described, as mentioned above. Here, as in the first embodiment, the organic EL element illustrated in FIG. 3B, which emits white light, was used in a configuration in which the color filter 20 is disposed between the microlens 15 and the light emission region 17. The microlens height h/D, the radius r/D, and height L2/D of the color filter top surface, normalized by the inter-pixel pitch D, are the same as in the first embodiment.

Table 8 shows the radiation angle dependence of a relative luminance ΔL in a first comparative example and an 11th working example. The first comparative example is a configuration in which the shift amount for the microlenses is 0. The 11th working example is a configuration in which the microlenses are shifted, and the values of the numerical aperture, φ1, φ2, and A are shown in Table 8. Referring to FIG. 19, which shows the results of the values in Table 8 and the first working example, in the first comparative example, the luminous intensity decreases as the radiation angle increases, peaking at 0°, and decreases to 0.6 at the normal light radiation angle of 22.5° when in the lower edge viewing state. On the other hand, the luminous intensity is high, at 0.47, at the radiation angle of -34° of the ghost light in the forward viewing state.

On the other hand, the results of the 11th working example show that the luminous intensity increases with progress toward the radiation direction of normal light, increasing to 1.0 at the radiation angle of 22.5° of normal light in the right edge viewing state. On the other hand, at the radiation angle of -34° of the ghost light in the forward viewing state, the value is significantly lower, at 0.23. In this manner, the luminous intensity of the normal light can be make higher than the luminous intensity in the direction of the ghosting. The increase in the luminous intensity of the normal light emission is due to the refraction of the light 27 incident on the surface 28, as indicated in FIG. 4C. The drop in the luminous intensity of the ghost light is due to total reflection or refraction to the wide-angle side that occurs at the surface 29 of the microlens of the adjacent light-emitting element, as indicated in FIG. 4C. φ1 in the 11th working example described here is 11.3, which satisfies Formula (5), which is the condition for the shift amount for the microlenses. Combining the polarizing optical system illustrated in FIG. 24 with a display element in which microlenses are shifted so as to satisfy Formula (5) in this manner makes it possible to increase the luminous intensity ΔL of normal light and simultaneously suppress ghost light.

Table 8

| | NUMERICAL APERTURE | φ1 | φ2 | A | LUMINOUS INTENSITY ΔL OF NORMAL LIGHT | LUMINOUS INTENSITY ΔL OF GHOST LIGHT |
|---|---|---|---|---|---|---|
| FIRST COMPARATIVE EXAMPLE | 30% | 0 | 0 | - | 0.6 | 0.47 |
| ELEVENTH WORKING EXAMPLE | 30% | 11.3 | 7.1 | 0.63 | 1.0 | 0.23 |

The effect of the numerical aperture of the light-emitting element will be described next. Table 9 shows the luminous intensity ΔL of normal light and ghost light for 11th to 13th working examples, which are examples having varying numerical apertures. The normal light at a numerical aperture of 40% was 0.93, but was 0.94 at a numerical aperture of 30% and 1.00 at a numerical aperture of 20%. In this manner, reducing the numerical aperture increases the luminous intensity of the normal light. This is due to an increase in the ratio of the region X to the light emission region 17, as indicated in FIG. 5A. In other words, this indicates that the light radiated in the light emission region is radiated in the normal light direction with high efficiency. On the other hand, with respect to the luminous intensity of ghost light, the value was 0.31 at a numerical aperture of 40%, but was 0.23 at a numerical aperture of 30% and 0.16 at a numerical aperture of 20%. It can therefore be seen that reducing the numerical aperture in this manner reduces the luminous intensity of the ghost light. The drop in the luminous intensity of the ghost light is due to a decrease in the overlap between the sum of the radiation regions Y1 and Y2 of the ghost light and the light emission region 17, indicated in FIG. 5B. In other words, in the freeform prism illustrated in FIGS. 24 to 26, under the condition that Formula (5) is satisfied, reducing the numerical aperture makes it possible to increase the normal light and reduce the ghost light.

Table 9

| | NUMERICAL APERTURE | $\varphi 1$ | $\varphi 2$ | A | LUMINOUS INTENSITY $\Delta L$ OF NORMAL LIGHT | LUMINOUS INTENSITY $\Delta L$ OF GHOST LIGHT |
|---|---|---|---|---|---|---|
| TWELFTH WORKING EXAMPLE | 40% | 11.3 | 7.1 | 0.63 | 0.93 | 0.31 |
| ELEVENTH WORKING EXAMPLE | 30% | 11.3 | 7.1 | 0.63 | 0.94 | 0.23 |
| THIRTEENTH WORKING EXAMPLE | 20% | 11.3 | 7.1 | 0.63 | 1.00 | 0.16 |

Table 10 shows the effect of the color filter shift amount $\Delta$CF. Table 10 shows the color shift $\Delta$E of the normal light and the luminous intensity $\Delta$L of the ghost light when $\varphi 1$ is fixed and $\varphi 2$ is varied (when A is varied). Table 10 also shows the first comparative example as reference values.

The color shift $\Delta$E of normal light at A = 0.63 is 7, but is 6 for A = 0.00 (without shifting the color filters). In other words, reducing the shift amount for the color filters reduces the color shift $\Delta$E of the normal light. In addition, the 11th working example and the 14th working example satisfy Formula (6), and thus the color shift $\Delta$E is smaller than that in the first comparative example. This drop in the color shift is due to light 33 radiated to the wide-angle side being blocked by the adjacent color filter, as illustrated in FIG. 6B. On the other hand, the ghost light was found to be independent of the shift amount for the color filters, being 0.23 at A = 0.63 and 0.22 at A = 0. In other words, this indicates that the color shift $\Delta$E of the normal light can be suppressed without increasing the luminous intensity of the ghost light. If A = 0.85 or less, the color shift $\Delta$E of normal light can be reduced more than when the shift amount for the microlenses is 0. In other words, in addition to satisfying the condition of Formula (5), satisfying Formula (6) makes it possible, in the freeform prism illustrated in FIGS. 24 to 26, to increase the luminous intensity of normal light and to suppress ghost light, as well as to reduce the color shift $\Delta$E.

Table 10

| | NUMERICAL APERTURE | $\varphi 1$ | $\varphi 2$ | A | COLOR SHIFT $\Delta E$ OF NORMAL LIGHT | LUMINOUS INTENSITY $\Delta L$ OF GHOST LIGHT |
|---|---|---|---|---|---|---|
| FIRST COMPARATIVE EXAMPLE | 30% | 0.0 | 0.0 | - | 8 | 0.47 |
| ELEVENTH WORKING EXAMPLE | 30% | 11.3 | 7.1 | 0.63 | 7 | 0.23 |
| FOURTEENTH WORKING EXAMPLE | 30% | 11.3 | 0.0 | 0.00 | 6 | 0.22 |

In this manner, in the present embodiment, shifting the microlens with respect to the pixel makes it possible to reduce ghost light while improving viewing angle characteristics such as luminance and color shift at the peripheral parts of an image observed with an ocular optical system using a freeform prism.

Although the freeform prism of the ocular optical system in the above-described embodiment is an optical system which does not have an intermediate image forming surface, an optical system having an intermediate image forming surface may be used as well. Additionally, a freeform prism may also be used as an optical element that couples the display surface of the display element to a waveguide combiner.

This application claims priority from Japanese Patent Application No. 2021-069268, filed April 15, 2021, which is hereby incorporated by reference herein.

**Claims**

1. An image observation apparatus **characterized by** comprising:

   a display element including a plurality of light-emitting elements disposed two-dimensionally on a plane and a plurality of microlenses provided for corresponding ones of the plurality of light-emitting elements; and
   an ocular optical system, containing at least one reflective surface therein, that guides light from a display surface of the display element to an exit pupil,
   wherein in a peripheral part of the display element, a light emission center of each light-emitting element and a center of the microlens corresponding to the light-emitting element are shifted from each other in a direction parallel to the plane.

2. The image observation apparatus according to claim 1, **characterized in that** in a peripheral part of the display element, a light emission center of each light-emitting element and a center of the microlens corresponding to the light-emitting element are shifted from each other in a direction parallel to the plane, such that a luminous intensity of normal light from the peripheral part of the display element that has passed through the ocular optical system increases and a luminous intensity of ghost light from the peripheral part of the display element that has passed through the ocular optical system decreases.

3. The image observation apparatus according to claim 1 or 2, **characterized in that** the ocular optical system includes a first phase plate, a semi-transmissive reflective surface, at least one lens, a second phase plate, and a polarization separation element that reflects first linearly-polarized light and transmits second linearly-polarized light having a polarization direction orthogonal to a polarization direction of the first linearly-polarized light, **in that** order from the display element toward the exit pupil.

4. The image observation apparatus according to claim 3, **characterized in that** the lens is a lens made of a resin.

5. The image observation apparatus according to claim 3 or 4, **characterized in that** the semi-transmissive reflective surface is provided on a surface of the lens, and the surface is a convex surface that is convex toward the display element.

6. The image observation apparatus according to claim 3 or 4, **characterized in that** the semi-transmissive reflective surface is provided on a surface of the lens, and the surface is aspheric.

7. The image observation apparatus according to any one of claims 3 to 6, **characterized in that** of the at least one lens, a lens on a side closest to the exit pupil is a plano-convex lens having a convex surface that is convex toward the display element.

8. The image observation apparatus according to any one of claims 3 to 7, **characterized in that** an uneven thickness ratio in an optically effective region of the at least one lens is at least 1.5 and at most 4.

9. The image observation apparatus according to any one of claims 3 to 8, **characterized in that** a slow axis of the first phase plate and a slow axis of the second phase plate are tilted in opposite directions with respect to a polarization direction of the first linearly-polarized light.

10. The image observation apparatus according to any one of claims 3 to 9, **characterized in that** the ocular optical system includes a polarizing plate, disposed between the polarization separation element and the exit pupil, that transmits the second linearly-polarized light.

11. The image observation apparatus according to any one of claims 3 to 10, **characterized in that** the ocular optical system includes a polarizing plate, disposed between the display element and the first phase plate, that transmits the first linearly-polarized light.

12. The image observation apparatus according to claim 1 or 2, **characterized in that** the ocular optical system is a freeform prism.

13. The image observation apparatus according to any one of claims 1 to 12, **characterized in that** the ocular optical system includes at least two reflective surfaces therein.

**14.** The image observation apparatus according to claim 13, **characterized in that** a number of reflections within the ocular optical system differs between an optical path of normal light and an optical path of ghost light in the ocular optical system.

**15.** The image observation apparatus according to any one of claims 1 to 14, **characterized in that** a shift amount between the light emission center of each light-emitting element and the center of the microlens corresponding to the light-emitting element in the direction parallel to the plane increases, and a change in the shift amount stays constant or increases, from a center of the display element toward the peripheral part.

**16.** The image observation apparatus according to any one of claims 1 to 15, **characterized in that** a numerical aperture of the light-emitting element is at most 52%.

**17.** The image observation apparatus according to any one of claims 1 to 16, **characterized in that** when a height of the microlens is represented by h, a height from a surface of an aperture in the light-emitting element to a bottom surface of the microlens is represented by L, a shift amount between a center of the light-emitting element and the center of the microlens in the direction parallel to the plane at the peripheral part of the display element is represented by $\Delta ML$, and an angle $\varphi 1$ determined by the height H, the height L, and the shift amount $\Delta ML$ is represented by $\varphi 1 = \arctan(\Delta ML/(h + L))$, $\varphi 1$ satisfies the following:

$$6.0° \leq \varphi 1 \leq 37.5°$$

**18.** The image observation apparatus according to claim 17, **characterized in that** the display element includes a color filter between the light-emitting element and the microlens, and when a height from the surface of the aperture of the light-emitting element to a top surface of the color filter is represented by L2, a shift amount between the light emission center of the light-emitting element and a center of the color filter in the direction parallel to the plane at the peripheral part of the display element is $\Delta CF$, an angle determined by the height L2 and the shift amount $\Delta CF$ is represented by $\varphi 2 = \arctan(\Delta CF/L2)$, and $A = \varphi 2/\varphi 1$ for a ratio A of the angle $\varphi 1$ and angle $\varphi 2$, A satisfies the following:

$$0 \leq A \leq 0.85$$

**19.** The image observation apparatus according to any one of claims 1 to 18, **characterized in that** an eye relief E1 of the ocular optical system satisfies the following:

$$15 \, mm \leq E1 \leq 25 \, mm$$

**20.** The image observation apparatus according to any one of claims 1 to 19, **characterized in that** a thickness L1 of the ocular optical system and an eye relief E1 of the ocular optical system satisfy the following:

$$0.6 \leq L1/E1 \leq 1.0$$

**21.** The image observation apparatus according to any one of claims 1 to 20, **characterized in that** an eye relief E1 of the ocular optical system and a maximum diagonal half-angle $\theta$ of the ocular optical system satisfy the following:

$$8 \, mm \leq E1 \times \tan\theta \leq 20 \, mm$$

**22.** The image observation apparatus according to any one of claims 1 to 21, **characterized in that** a center of the microlens is a center of gravity of a shape formed from lines connecting edges in plan view.

**23.** The image observation apparatus according to any one of claims 1 to 22, **characterized in that** the display surface of the display element is an n-polygon (where $n \geqq 5$).

**24.** The image observation apparatus according to any one of claims 1 to 23, **characterized in that** either or both of the light-emitting element and the microlens are not disposed in at least one diagonal region of the display element.

25. The image observation apparatus according to any one of claims 1 to 24, **characterized in that** in the peripheral part of the display element, when an angle of radiation of main light rays of normal light is represented by $\theta m$ and an angle of radiation of ghost light is represented by $\theta g$, $\theta m$ and $\theta g$ satisfy the following:

$$|\theta m - \theta g| \geq 15°$$

# F I G. 1

# F I G. 2

# FIG. 3A

# FIG. 3B

# FIG. 3C

FIG. 4A

FIG. 4B

# FIG. 4C

# F I G. 5A

**F I G. 5B**

**F I G. 5C**

F I G. 6A

F I G. 6B

# FIG. 7

# FIG. 8A

# FIG. 8B

# FIG. 9

1000

1001

1002

1003

1004

1005

100

1006

1007

1008

1009

# F I G. 10A

# F I G. 10B

# F I G. 11A

1300

1301  1302

1303

# F I G. 11B

1310  1314

1311

1312

1313

# F I G. 12A

# F I G. 12B

# F I G. 13A

1600

1603

1601

1602

# F I G. 13B

1610

1612

1611

FIG. 14

# F I G. 15

# F I G. 16

# F I G. 17

# F I G. 18

# F I G. 19

RADIATION ANGLE OF
GHOST LIGHT

RADIATION ANGLE OF
NORMAL LIGHT

RELATIVE
LUMINOUS
INTENSITY
[Arbi.uni.]

RADIATION ANGLE [°]

FIRST COMPARATIVE
EXAMPLE
FIRST WORKING
EXAMPLE

EP 4 325 280 A1

# F I G. 20

# FIG. 21

# FIG. 22

# FIG. 23

# F I G. 24

# F I G. 25

# FIG. 26

306

304

# FIG. 27A

306

# FIG. 27B

306

# INTERNATIONAL SEARCH REPORT

| International application No. |
|---|
| **PCT/JP2022/014130** |

**A. CLASSIFICATION OF SUBJECT MATTER**

*G02B 27/02*(2006.01)i; *G02B 3/00*(2006.01)i; *G02C 11/00*(2006.01)i; *H04N 5/64*(2006.01)i
FI: G02B27/02 Z; G02B3/00 A; H04N5/64 511A; G02C11/00

According to International Patent Classification (IPC) or to both national classification and IPC

**B. FIELDS SEARCHED**

Minimum documentation searched (classification system followed by classification symbols)

G02B27/02; G02B3/00; G02C11/00; H04N5/64

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2020-184478 A (SEIKO EPSON CORP) 12 November 2020 (2020-11-12) paragraphs [0008]-[0082], [0119], [0123], fig. 3-9, 29 | 1, 15, 22 |
| Y | paragraphs [0008]-[0082], [0119], [0123], fig. 3-9, 29 | 2-17, 19-24 |
| A | entire text, all drawings | 18, 25 |
| X | JP 10-228245 A (OLYMPUS OPTICAL CO LTD) 25 August 1998 (1998-08-25) paragraphs [0004]-[0017], [0021]-[0022], [0056]-[0058], fig. 2, 3, 26 | 1, 15 |
| Y | paragraphs [0004]-[0017], [0021]-[0022], [0056]-[0058], fig. 2, 3, 26 | 2-17, 19-21, 23-24 |
| A | entire text, all drawings | 18,25 |
| Y | JP 2020-95205 A (CANON KK) 18 June 2020 (2020-06-18) paragraphs [0012]-[0048], fig. 1-7 | 2-17, 19-24 |
| Y | JP 11-142783 A (OLYMPUS OPTICAL CO LTD) 28 May 1999 (1999-05-28) paragraphs [0011]-[0012], fig. 1(a)-1(c) | 12-17, 19-24 |
| Y | JP 2015-172616 A (PANASONIC CORP) 01 October 2015 (2015-10-01) paragraph [0068] | 23, 24 |

☐ Further documents are listed in the continuation of Box C.  ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **27 May 2022** | **07 June 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
Information on patent family members

International application No.

**PCT/JP2022/014130**

| Patent document cited in search report | | | Publication date (day/month/year) | Patent family member(s) | Publication date (day/month/year) |
|---|---|---|---|---|---|
| JP | 2020-184478 | A | 12 November 2020 | US 2020/0357854 A1 paragraphs [0036]-[0111], [0150]-[0156], fig. 3-9, 29 CN 111916480 A | |
| JP | 10-228245 | A | 25 August 1998 | (Family: none) | |
| JP | 2020-95205 | A | 18 June 2020 | US 2020/0192079 A1 paragraphs [0026]-[0063], fig. 1-7 | |
| JP | 11-142783 | A | 28 May 1999 | US 6124977 A column 4, line 25 to column 5, line 2, fig. 1(a)-1(c) | |
| JP | 2015-172616 | A | 01 October 2015 | (Family: none) | |

Form PCT/ISA/210 (patent family annex) (January 2015)

**EP 4 325 280 A1**

**REFERENCES CITED IN THE DESCRIPTION**

**Patent documents cited in the description**

- JP 2019053152 A
- JP 2019061198 A
- JP 2021069268 A